# EUROPEAN PATENT APPLICATION

(11) **EP 4 246 576 A1**
(43) Date of publication of application: **20.09.2023**
(21) Application number: 23161991.7
(22) Date of filing: 15.03.2023
(51) Int. Cl.: H01L 25/075, H01L 33/62, H01L 33/00

(54) **DISPLAY DEVICE**

(30) Priority: 16.03.2022 KR 20220032979
(71) Applicant: Samsung Display Co., Ltd., Yongin-si, Gyeonggi-do 17113 (KR)
(72) Inventor: KIM, Kyung Bae, Yongin-si 17113 (KR); LEE, Yong Hee, Yongin-si 17113 (KR); HONG, Sung Chul, Yongin-si 17113 (KR)
(74) Representative: Marks & Clerk LLP

(57) **Abstract**

A display device comprises a first line extending in a first direction, a second line spaced apart from the first line in a second direction, sub-pixels including emission areas between the first line and the second line, light-emitting elements in light-emitting element arrangement areas in the emission areas, a bank pattern overlapping with the first line and the second line, and defining openings corresponding to the light-emitting element arrangement areas, and a bank surrounding the emission areas, and overlapping with the first line, the second line, and the bank pattern.

## Description

### BACKGROUND

### 1. Field

The present disclosure generally relates to a display device.

### 2. Related Art

Recently, interest in information displays has been increased. Accordingly, research and development of display devices have been continuously conducted.

### SUMMARY

Embodiments provide a display device capable of reducing or preventing overflow of a light-emitting element ink including light-emitting elements.

In accordance with an aspect of the present disclosure, there is provided a display device including a first line extending in a first direction, a second line spaced apart from the first line in a second direction, sub-pixels including emission areas between the first line and the second line, light-emitting elements in light-emitting element arrangement areas in the emission areas, a bank pattern overlapping with the first line and the second line, and defining openings corresponding to the light-emitting element arrangement areas, and a bank surrounding the emission areas, and overlapping with the first line, the second line, and the bank pattern.

The second line may extend in the first direction, wherein the bank pattern may include a first pattern part overlapping the first line, and continuously formed along the first direction at a periphery of the emission areas, a second pattern part overlapping the second line, and continuously formed along the first direction at the periphery of the emission areas, and third pattern parts at respective sides of the light-emitting element arrangement areas in the first direction, and extending in the second direction.

The bank may be continuously formed along the first direction at a portion overlapping with the first pattern part and the second pattern part.

The first line may be a scan line configured to transmit a scan signal, wherein the second line is a power line configured to transmit a first power voltage or a second power voltage.

The sub-pixels may include a first alignment electrode at a periphery of first end portions of the light-emitting elements, and extending in the second direction, wherein the first alignment electrode includes an end portion at a portion of a non-emission area adjacent to an emission area of a corresponding sub-pixel in the second direction.

The first alignment electrode may be electrically connected to the first end portions of the light-emitting elements.

The sub-pixels may further include a pixel circuit electrically connected to the first alignment electrode.

The sub-pixels may further include a second alignment electrode at a periphery of second end portions of the light-emitting elements, and extending in the second direction.

The display device may further include a power line electrically connected to the second alignment electrode.

The sub-pixels may include a first sub-pixel, a second sub-pixel, and a third sub-pixel, which constitute one pixel, and respectively may include a first emission area, a second emission area, and a third emission area, and that are arranged in the first direction between the first line and the second line.

The first line, the bank pattern, and the bank may completely overlap with each other in a non-emission area immediately adjacent to first edge areas of the first emission area, the second emission area, and the third emission area, wherein the second line, the bank pattern, and the bank completely overlap with each other in a non-emission area immediately adjacent to second edge areas of the first emission area, the second emission area, and the third emission area.

The first sub-pixel may further include a first pixel circuit electrically connected to light-emitting elements in the first emission area among the light-emitting elements, wherein the second sub-pixel may further include a second pixel circuit electrically connected to light-emitting elements in the second emission area among the light-emitting elements, and wherein the third sub-pixel may further include a third pixel circuit electrically connected to light-emitting elements in the third emission area among the light-emitting elements.

The first pixel circuit, the second pixel circuit, and the third pixel circuit may be arranged in the second direction.

The second line may be between the second pixel circuit and the third pixel circuit.

The first pixel circuit and the third pixel circuit may be between the first line and the second line.

The sub-pixels may include a light-emitting unit including at least one light-emitting element in a corresponding emission area among the light-emitting elements, and electrodes electrically connected to the at least one light-emitting element, and a pixel circuit including circuit elements electrically connected to the light-emitting unit.

The display device may further include a circuit layer including pixel circuits of the sub-pixels, the first line, and the second line, and a display layer overlapping with the circuit layer, and including light-emitting units of the sub-pixels.

The circuit layer may include conductive layers sequentially arranged along a third direction crossing the first direction and the second direction, wherein a conductive layer closest to the display layer among the conductive layers includes the first line and the second line.

The display device may further include at least two pixels each including sub-pixels among the sub-pixels, the at least two pixels being arranged in the first direction, wherein the bank pattern includes individual patterns formed by separating patterns corresponding to each of the at least two pixels from each other, or includes an integrated pattern in which patterns corresponding to each of the at least two pixels are integrally formed.

In accordance with another aspect of the present disclosure, there is provided a display device including a first line and a second line extending in a first direction, and spaced apart from each other in a second direction, a first sub-pixel including first light-emitting elements in a first emission area between the first line and the second line, a second sub-pixel including second light-emitting elements in a second emission area that is adjacent to the first emission area in the first direction, and that is between the first line and the second line, a third sub-pixel including third light-emitting elements in a third emission area that is adjacent to the second emission area in the first direction, and that is between the first line and the second line, a bank pattern overlapping with the first line and the second line, and defining openings respectively corresponding to light-emitting element arrangement areas in the first emission area, the second emission area, and the third emission area, and a bank surrounding the first to third emission areas, and overlapping with the first line, the second line, and the bank pattern, wherein, at a portion immediately adjacent to both ends of the first emission area, the second emission area, and the third emission area in the second direction, the bank pattern and the bank overlap with the first line and the second line and are continuously formed along the first direction.

At least some of the above and other features of the invention are set out in the claims.

### BRIEF DESCRIPTION OF THE DRAWINGS

Embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.
FIG. 1 is a perspective view illustrating a light-emitting element in accordance with one or more embodiments of the present disclosure.
FIG. 2 is a sectional view illustrating the light-emitting element in accordance with one or more embodiments of the present disclosure.
FIG. 3 is a plan view illustrating a display device in accordance with one or more embodiments of the present disclosure.
FIGS. 4 and 5 are circuit diagrams illustrating sub-pixels in accordance with embodiments of the present disclosure.
FIG. 6 is a plan view illustrating a display area in accordance with one or more embodiments of the present disclosure.
FIG. 7 is a sectional view illustrating a display area in accordance with one or more embodiments of the present disclosure.
FIG. 8 is a plan view illustrating a circuit layer of the display area in accordance with one or more embodiments of the present disclosure.
FIG. 9 is a plan view illustrating a display layer of the display area in accordance with one or more embodiments of the present disclosure.
FIGS. 10 and 11 are plan views illustrating display layers of the display area in accordance with embodiments of the present disclosure.
FIG. 12 is a sectional view illustrating a display area in accordance with one or more embodiments of the present disclosure.

### DETAILED DESCRIPTION

Aspects of some embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may have various modifications and may be embodied in various different forms, and should not be construed as being limited to only the illustrated embodiments herein. Rather, these embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the particular illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. The term "connection" may inclusively mean physical and/or electrical connection, may inclusively mean direct connection and indirect connection, and may inclusively mean integrated connection and non-integrated connection. However, "directly connected/directly coupled," or "directly on," refers to one component directly connecting or coupling another component, or being on another component, without an intermediate component. In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. Similarly, the expression such as "at least one of A and B" may include A, B, or A and B. As used herein, "or" generally means "and/or," and the term "and/or" includes any and all combinations of one or more of the associated listed items. For example, the expression such as "A and/or B" may include A, B, or A and B.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

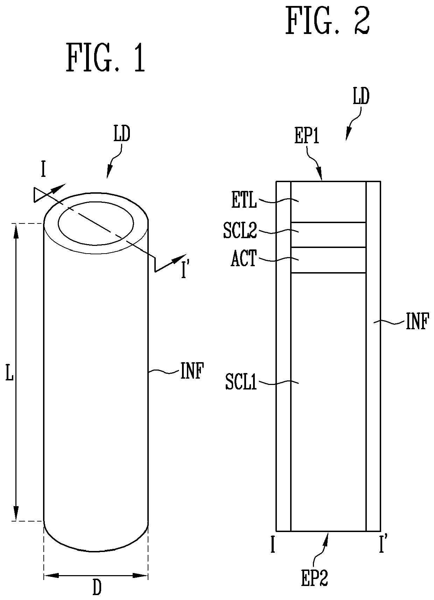

FIG. 1 is a perspective view illustrating a light-emitting element LD in accordance with one or more embodiments of the present disclosure. FIG. 2 is a sectional view illustrating the light-emitting element LD in accordance with one or more embodiments of the present disclosure. For example, FIG. 1 illustrates an example of a light-emitting element LD that can be used as a light source of a pixel in accordance with one or more embodiments of the present disclosure, and FIG. 2 illustrates an example of a section of the light-emitting element LD, which corresponds to the line I-I' shown in FIG. 1.

Referring to FIGS. 1 and 2, the light-emitting element LD may include a first semiconductor layer SCL1, an active layer ACT (also referred to as a "light-emitting layer"), and a second semiconductor layer SCL2, which are sequentially located and/or stacked along one direction (e.g., a length direction), and an insulative film INF surrounding outer circumferential surfaces (e.g., side surfaces) of the first semiconductor layer SCL1, the active layer ACT, and the second semiconductor layer SCL2. In one or more embodiments, the light-emitting element LD may further include an electrode layer ETL located on the second semiconductor layer SCL2. The insulative film INF may at least partially surround an outer circumferential surface of the electrode layer ETL or may not surround the outer circumferential surface of the electrode layer ETL. In some embodiments, the light-emitting element LD may further include another electrode layer located on one surface (e.g., a lower surface) of the first semiconductor layer SCL1.

In one or more embodiments, the light-emitting element LD may be provided in a rod shape. In the description of one or more embodiments of the present disclosure, the rod shape may include various forms of rod-like shape or bar-like shape, including a circular pillar shape, a polygonal pillar shape, and the like, and the shape of a section of the rod shape is not particularly limited. In one or more embodiments, a length L of the light-emitting element LD may be greater than a diameter D (or a width of a cross-section) of the light-emitting element LD.

The light-emitting element LD may include a first end portion EP1 and a second end portion EP2. In one or more embodiments, the first end portion EP1 and the second end portion EP2 may face each other. For example, the light-emitting element LD may include the first end portion EP1 and the second end portion EP2 at respective ends thereof in the length direction (or thickness direction). The first end portion EP1 of the light-emitting element LD may include a first base surface (e.g., an upper surface) of the light-emitting element LD and/or a peripheral area thereof. The second end portion EP2 of the light-emitting element LD may include a second base surface (e.g., a lower surface) of the light-emitting element LD and/or a peripheral area thereof.

The first semiconductor layer SCL1, the active layer ACT, the second semiconductor layer SCL2, and the electrode layer ETL may be sequentially located in a direction from the second end portion EP2 to the first end portion EP1 of the light-emitting element LD. For example, the electrode layer ETL (or the second semiconductor layer SCL2) may be located at the first end portion EP1 of the light-emitting element LD, and the first semiconductor layer SCL1 (or another electrode layer that is adjacent to the first semiconductor layer SCL1 and is electrically connected to the first semiconductor layer SCL1) may be located at the second end portion EP2 of the light-emitting element LD.

The first semiconductor layer SCL1 may include a first conductivity type semiconductor layer including a first conductivity type dopant. For example, the first semiconductor layer SCL1 may be an N-type semiconductor layer including an N-type dopant.

In one or more embodiments, the first semiconductor layer SCL1 may include a nitride-based semiconductor material or a phosphide-based semiconductor material. In one or more embodiments, the first semiconductor layer SCL1 may include a nitride-based semiconductor material including at least one material among GaN, AlGaN, InGaN, AlInGaN, AlN, and InN, or a phosphide-based semiconductor material including at least one material among GaP, GaInP, AlGaP, AlGaInP, AlP, and InP. In one or more embodiments, the first semiconductor layer SCL1 may include an N-type dopant such as Si, Ge or Sn. The first semiconductor layer SCL1 may be formed by using another material in addition to the aforementioned materials.

The active layer ACT may be located on the first semiconductor layer SCL1. The active layer ACT may include a single- or multi-quantum well (QW) structure. When a voltage that is a threshold voltage or higher is applied across both ends of the light-emitting element LD, electron-hole pairs may be combined in the active layer ACT, and accordingly, light can be emitted in the light-emitting element LD.

In one or more embodiments, the active layer ACT may emit light having a visible light wavelength band (e.g., light having a wavelength of about 400 nm to about 900 nm). For example, the active layer ACT may emit blue light, which has a wavelength in a range of about 450 nm to about 480 nm, green light, which has a wavelength in a range of about 480 nm to about 500 nm, or red light, which has a wavelength in a range of about 620 nm to about 750 nm. The active layer ACT may emit light of another color and/or another wavelength band in addition to the aforementioned color and/or the aforementioned wavelength band.

In some embodiments, the active layer ACT may include a nitride-based semiconductor material or a phosphide-based semiconductor material. In one or more embodiments, the active layer ACT may include a nitride-based semiconductor material including at least one material among GaN, AlGaN, InGaN, InGaAlN, AIN, InN, and AlInN, or a phosphide-based semiconductor material including at least one material among GaP, GaInP, AlGaP, AlGaInP, AlP, and InP. The material constituting the active layer ACT is not limited thereto. The active layer ACT may be formed by using another material in addition to the aforementioned materials.

The second semiconductor layer SCL2 may be located on the active layer ACT. The second semiconductor layer SCL2 may include a second conductivity type semiconductor layer including a second conductivity type dopant. For example, the second semiconductor layer SCL2 may be a P-type semiconductor layer including a P-type dopant.

In one or more embodiments, the second semiconductor layer SCL2 may include a nitride-based semiconductor material or a phosphide-based semiconductor material. In one or more embodiments, the second semiconductor layer SCL2 may include a nitride-based semiconductor material including at least one material among GaN, AlGaN, InGaN, AlInGaN, AlN, and InN, or a phosphide-based semiconductor material including at least one material among GaP, GaInP, AlGaP, AlGaInP, AlP, and InP. In one or more embodiments, the second semiconductor layer SCL2 may include a P-type dopant such as Mg. The second semiconductor layer SCL2 may be formed by using another material in addition to the aforementioned materials.

In one or more embodiments, the first semiconductor layer SCL1 and the second semiconductor layer SCL2 include the same semiconductor material, and may include dopants of different conductivity types. In one or more other embodiments, the first semiconductor layer SCL1 and the second semiconductor layer SCL2 include different semiconductor materials, and may include dopants of different conductivity types.

In one or more embodiments, the first semiconductor layer SCL1 and the second semiconductor layer SCL2 may have different lengths (or different thicknesses) in the length direction of the light-emitting element LD. In one or more embodiments, the first semiconductor layer SCL1 may have a length (or thickness) that is longer (or thicker) than a length (or thickness) of the second semiconductor layer SCL2 along the length direction of the light-emitting element LD. Accordingly, the active layer ACT may be located closer to the first end portion EP1 (e.g., a P-type end portion) than the second end portion EP2 (e.g., an N-type end portion).

The electrode layer ETL may be located on the second semiconductor layer SCL2. The electrode layer ETL may be an electrode for protecting the second semiconductor layer SCL2, and for smoothly connecting the second semiconductor layer SCL2 to at least one circuit element, at least one electrode, and/or at least one line. For example, the electrode layer ETL may be an ohmic contact electrode or a Schottky contact electrode.

In some embodiments, the electrode layer ETL may include a metal or metal oxide. In one or more embodiments, the electrode layer ELT may be formed of one or a mixture of a metal such as chromium (Cr), titanium (Ti), aluminium (Al), gold (Au), nickel (Ni) or copper (Cu), any oxide or alloy thereof, a transparent conductive material such as indium tin oxide (ITO), indium zinc oxide (IZO), indium tin zinc oxide (ITZO), zinc oxide (ZnO) or indium oxide (In₂O₃), and the like. The electrode layer ETL may be formed by using another conductive material in addition to the aforementioned materials.

In some embodiments, the electrode layer ETL may be substantially transparent. Accordingly, light generated in the light-emitting element LD can be transmitted through the electrode layer ETL.

The insulative film INF may be provided on a surface of the light-emitting element LD to surround side surfaces of the first semiconductor layer SCL1, the active layer ACT, the second semiconductor layer SCL2, and/or the electrode layer ETL. Accordingly, the electrical stability of the light-emitting element LD can be ensured, and the likelihood of a short-circuit defect through the light-emitting element LD can be reduced or prevented.

The insulative film INF may expose the electrode layer ETL (or the second semiconductor layer SCL2) and the first semiconductor layer SCL1 (or another electrode layer provided at the second end portion EP2 of the light-emitting element LD) at the first end portion EP1 and the second end portion EP2 of the light-emitting element LD, respectively. For example, the insulative film INF may be omitted from two base surfaces (e.g., upper and lower surfaces of the light-emitting element LD) corresponding to the first and second end portions EP1 and EP2 of the light-emitting element LD. Accordingly, each of the first end portion EP1 and the second end portion EP2 of the light-emitting element LD is connected to at least one electrode, at least one line, and/or at least one conductive pattern, to thereby apply an electrical signal (e.g., a driving signal and/or a power voltage) to the light-emitting element LD.

When the insulative film INF is provided on the surface of the light-emitting element LD, a surface defect of the light-emitting element LD is reduced or minimized, thereby improving the lifetime and efficiency of the light-emitting element LD. In addition, the likelihood of a short-circuit defect between light-emitting elements can be reduced or prevented even when the light-emitting elements LD are adjacent to each other.

In one or more embodiments, the light-emitting element LD may be manufactured through a surface treatment process. For example, the light-emitting element LD may be surface-treated by using a hydrophobic material. Accordingly, when a plurality of light-emitting elements LD are mixed in a liquid solution (or solvent) to be supplied to each emission area (e.g., an emission area of each pixel and/or each sub-pixel), the light-emitting elements LD are not unequally condensed in the solution but equally dispersed in the solution.

The insulative film INF may include a transparent insulating material. Accordingly, light generated in the active layer ACT can be transmitted through the insulative film INF. For example, the insulative film INF may include at least one insulating material among silicon oxide (SiOₓ) (e.g., SiO₂), silicon nitride (SiNₓ) (e.g., Si₃N₄), aluminium oxide (AlₓO_{y}) (e.g., Al₂O₃), and titanium oxide (TiₓO_{y}) (e.g., TiO₂). The insulative film INF may be formed by using another insulating material in addition to the aforementioned material.

The insulative film INF may be a single layer or a multilayer. In one or more embodiments, the insulative film INF may be configured as a double layer.

In one or more embodiments, the insulative film INF may be partially etched (or removed) at a portion corresponding to at least one of the first end portion EP1 and the second end portion EP2 of the light-emitting element LD. In one or more embodiments, the insulative film INF may be etched to be inclined at the first end portion EP1 of the light-emitting element LD.

In one or more embodiments, the light-emitting element LD may have a small size in a range of nanometers to micrometers. For example, the light-emitting element LD may have a diameter D (or a width of a cross-section) in the range of nanometers to micrometers. In one or more embodiments, may have a diameter D and/or a length L in a range of about a few tens of nanometers to about a few tens of micrometers.

The structure, shape, size, and/or kind of the light-emitting element LD may be changed in some embodiments. For example, the structure, shape, size, and/or kind of the light-emitting element LD may be variously changed according to design conditions of a light-emitting device using the light-emitting element LD, light emission characteristics to be secured, or the like.

A light-emitting device including the light-emitting element LD may be used in various kinds of devices that require a light source. For example, light-emitting elements LD may be located in a pixel of a display device, and may be used as a light source of the pixel. The light-emitting element LD may be used in other types of devices that require a light source, such as a lighting device.

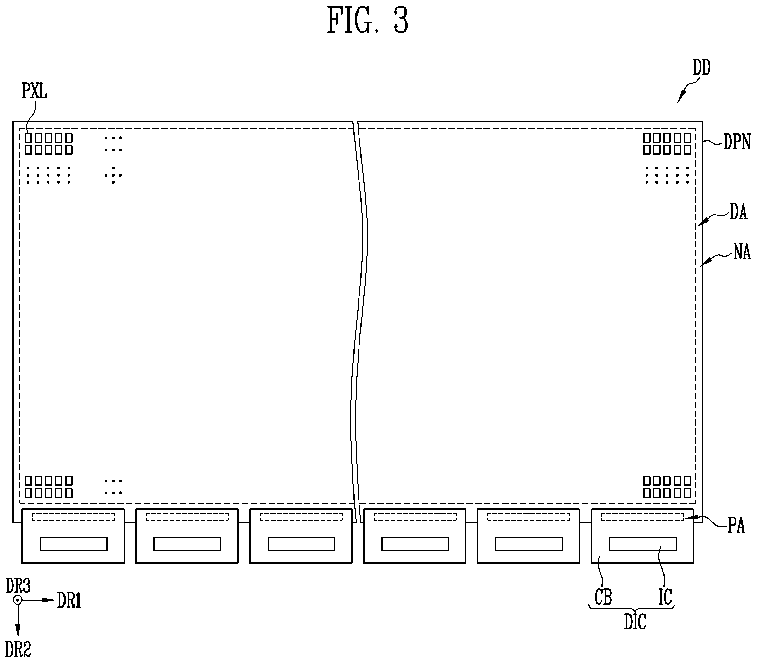

FIG. 3 is a plan view illustrating a display device DD in accordance with one or more embodiments of the present disclosure.

Referring to FIG. 3, the display device DD may include a display panel DPN including pixels PXL, and at least one driving circuit DIC connected to the display panel DPN. In one or more embodiments, the display device DD may include two or more driving circuits DIC.

The display panel DPN may include a display area DA in which the pixels PXL are located, and a non-display area NA located at the periphery of the display area DA. Lines and/or pads, which are electrically connected to the pixels PXL may be located in the non-display area NA. In one or more embodiments, the non-display area NA may be located at an edge of the display panel DPN, and may surround the display area DA.

The pixels PXL may be arranged in the display area DA along at least one direction. For example, the pixels PXL may be regularly arranged in the display area DA along a first direction DR1 and a second direction DR2. In one or more embodiments, the first direction DR1 may be a horizontal direction (or lateral direction) of the display area DA, and the second direction DR2 may be a vertical direction (or longitudinal direction) of the display area DA. The arrangement structure and/or arrangement direction of the pixels PXL may be changed in some embodiments.

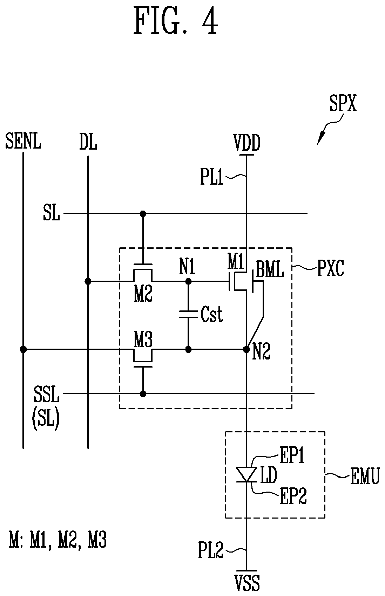

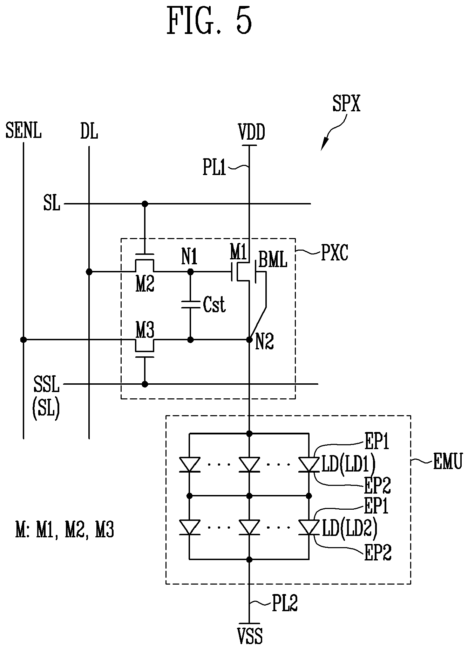

Each pixel PXL (also referred to as a "unit pixel") may include a sub-pixel (e.g., a sub-pixel SPX shown in FIG. 4 or 5). For example, each pixel PXL may include two or more sub-pixels SPX for emitting lights of different colors.

The driving circuit DIC (e.g., a driving integrated circuit) may be located on a pad area PA of the display panel DPN. For example, the driving circuit DIC may be located on the pad area PA of the display panel DPN in a third direction DR3 (e.g., a thickness or height direction of the display device DD) crossing the first direction DR1 and the second direction DR2. The driving circuit DIC may be electrically connected to pads provided in the pad area PA, and may supply driving signals to the display panel DPN through the pads.

The driving circuit DIC may include a circuit board CB and an integrated circuit IC. The circuit board CB may be a flexible print circuit board (FPCB), a polymer film, or another type of substrate or film. In one or more embodiments, the driving circuit DIC may be attached onto the pad area PA in the form of a tape automated bonding (TAB)-IC. The TAB-IC may include a tape carrier package (TCP) obtained by mounting an integrated circuit IC in a chip form on a polymer film and a chip on film (COF) obtained by mounting an integrated circuit IC in a chip form on a flexible printed circuit board. The driving circuit DIC may be provided in another form or another structure.

The integrated circuit IC may include a driver for driving the pixels PXL. For example, the driving circuit DIC may include a scan driver (also referred to as a "gate driver") for supplying scan signals and/or control signals to scan lines and/or control lines of pixels PXL (or sub-pixels SPX constituting the pixels PXL), and a data driver (also referred to as a "source driver") for supplying data signals to data lines of the pixels PXL. In one or more other embodiments, at least a portion of the scan driver and/or the data driver may be provided and/or formed in the display panel DPN, or may be mounted on another board or the like to be connected to the display panel DPN. In one or more embodiments, the data driver may include a sensing circuit for sensing characteristics of the pixels PXL. In one or more other embodiments, the display device DD may include a separate sensing circuit separated from the data driver.

In one or more embodiments, the display panel DPN may be partitioned into two or more parts or areas, and the display device DD may include two or more driving circuits DIC corresponding the respective parts or areas. Each driving circuit DIC may be electrically connected to pixels PXL located in a corresponding part or area, to supply driving signals to the pixels PXL.

The display device DD may further include an additional component. For example, the display device DD may further include a timing controller electrically connected to the integrated circuit IC and a power voltage generator electrically connected to the pixels PXL and the integrated circuits IC. In one or more embodiments, the timing controller and the power voltage generator may be mounted and/or formed on a separated circuit board electrically connected to the driving circuits DIC, but embodiments are not limited thereto.

In one or more embodiments, the driving circuits DIC may be located on only one edge area of the display panel DPN to be adjacent to any one side of the display area DA. For example, the driving circuits DIC may be located only on one portion (e.g., a portion corresponding to the pad areas PA and a peripheral area thereof) of the non-display area NA, which corresponds to a bottom edge area (or top edge area) of the display panel DPN. The display device DD may be a single side driving display device in which driving signals are supplied to the display panel DPN through pads located in a bottom edge area (or top edge area) of the display panel DPN and through driving circuits DIC electrically connected to the pads.

In the case of the single side driving display device, the driving circuits DIC (or the pads connected to the driving circuits DIC) may not be located on the other areas (e.g., a top end edge area, a left edge area, and/or a right edge area of the display panel DPN) in contact with other sides of the display area DA in the non-display area NA of the display panel DPN. Accordingly, in the other areas of the non-display area NA, the width and/or area of the non-display area NA can be reduced or minimized.

FIGS. 4 and 5 are circuit diagrams illustrating sub-pixels SPX in accordance with embodiments of the present disclosure. For example, FIGS. 4 and 5 illustrate sub-pixels SPX including light-emitting units EMU having different structures.

The sub-pixel SPX shown in FIG. 4 or 5 may be one of the sub-pixels SPX located in the display area DA shown in FIG. 3. The sub-pixels SPX located in the display area DA may have structures substantially identical or similar to each other.

Referring to FIGS. 4 and 5, the sub-pixel SPX may be connected to a scan line SL, a data line DL, a first power line PL1, and a second power line PL2. In one or more embodiments, the sub-pixel SPX may be further connected to another power line and/or another signal line. For example, the sub-pixel SPX may be further connected to a sensing line SENL (also referred to as an "initialization power line") and/or a control line SSL.

The sub-pixel SPX may include a light-emitting unit EMU for generating light with a luminance corresponding to each data signal. Also, the sub-pixel SPX may further include a pixel circuit PXC for driving the light-emitting unit EMU.

The pixel circuit PXC may be connected to the scan line SL and the data line DL, and may be connected between the first power line PL1 and the light-emitting unit EMU. For example, the pixel circuit PXC may be electrically connected to the scan line SL to which a scan signal is supplied, the data line DL to which a data signal is supplied, the first power line PL1 to which a first power voltage VDD is applied, and the light-emitting unit EMU.

The pixel circuit PXC may be selectively further connected to the control line SSL to which a control signal is supplied, and the sensing line SENL connected to a reference power source (or initialization power source) or to a sensing circuit, respectively corresponding to a display period or a sensing period. In one or more embodiments, the scan signal and the control signal, which are supplied to the sub-pixel SPX, (e.g., a scan signal and a control signal, which are supplied to sub-pixels SPX and/or pixels PXL of a corresponding horizontal line) may be identical to or different from each other. In one or more embodiments, when the scan signal and the control signal of the sub-pixel SPX are the same signal, the scan line SL and the control line SSL, which are connected to the sub-pixel SPX, may be integrated.

The pixel circuit PXC may include at least one transistor and a capacitor. For example, the pixel circuit PXC may include a first transistor M1, a second transistor M2, a third transistor M3, and a storage capacitor Cst.

The first transistor M1 may be electrically connected between the first power line PL1 and a second node N2. The second node N2 may be a node at which the pixel circuit PXC and the light-emitting unit EMU are connected to each other. For example, the second node N2 may be a node at which one electrode (e.g., a source electrode) of the first transistor M1 and the light-emitting unit EMU are electrically connected to each other. A gate electrode of the first transistor M1 may be electrically connected to a first node N1. The first transistor M1 may control a driving current supplied to the light-emitting unit EMU corresponding to a voltage of the first node N1. For example, the first transistor M1 may be a driving transistor of the sub-pixel SPX.

In one or more embodiments, the first transistor M1 may further include a bottom metal layer BML (also referred to as a "back-gate electrode" or a "second gate electrode"). In one or more embodiments, the bottom metal layer BML may be electrically connected to the one electrode (e.g., the source electrode) of the first transistor M1.

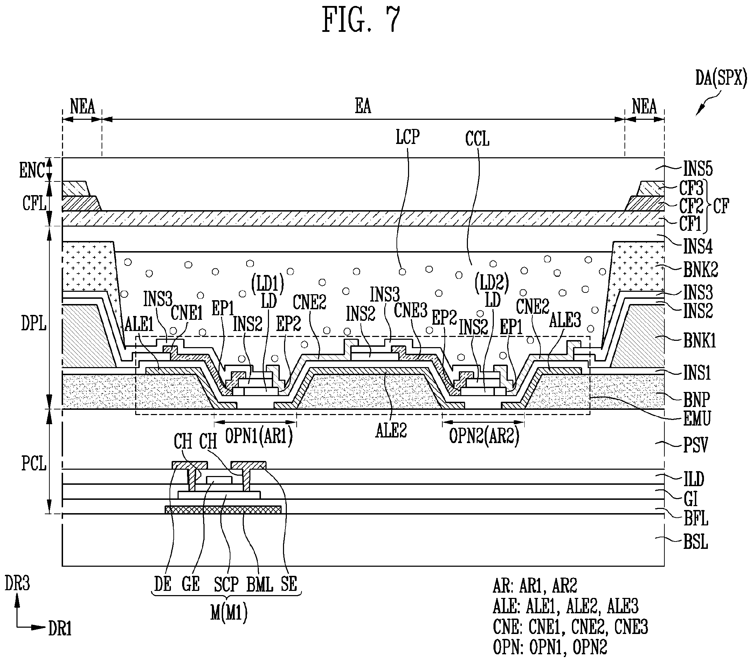

In one or more embodiments in which the first transistor M1 includes the bottom metal layer BML, a back-biasing technique (or sync technique) may be applied, wherein a threshold voltage of the first transistor M1 is moved in a negative direction or positive direction by applying a back-biasing voltage to the bottom metal layer BML of the first transistor M1. In addition, when the bottom metal layer BML is located on the bottom of a semiconductor pattern (e.g., a semiconductor pattern SCP shown in FIG. 7) constituting a channel of the first transistor M1, light incident onto the semiconductor pattern may be blocked, thereby stabilizing an operating characteristic of the first transistor M1.

The second transistor M2 may be electrically connected between the data line DL and the first node N1. In addition, a gate electrode of the second transistor M2 may be electrically connected to the scan line SL. The second transistor M2 may be turned on when a scan signal having a gate-on voltage (e.g., a logic high voltage or high level voltage) is supplied from the scan line SL to electrically connect the data line DL and the first node N1.

A data signal of a corresponding frame may be supplied to the data line DL for each frame period. The data signal may be transferred to the first node N1 through the second transistor M2 during a period in which the scan signal having the gate-on voltage is supplied. For example, the second transistor M2 may be a switching transistor for transferring each data signal to the inside of the sub-pixel SPX.

The capacitor Cst may be electrically connected between the first node N1 and the second node N2. The capacitor Cst may charge a voltage corresponding to the data signal supplied to the first node N1 during each frame period.

The third transistor M3 may be electrically connected between the second node N2 and the sensing line SENL. In addition, a gate electrode of the third transistor M3 may be electrically connected to the control line SSL (or the scan line SL). The third transistor M3 may be turned on when a control signal (or the scan signal) having the gate-on voltage (e.g., the logic high voltage or high level voltage) is supplied from the control line SSL to transfer a reference voltage (or initialization voltage) supplied via the sensing line SENL to the second node N2, or to transfer a voltage of the second node N2 to the sensing line SENL. In one or more embodiments, the voltage of the second node N2 may be transferred to the sensing circuit through the sensing line SENL, and a characteristic deviation and/or a change of sub-pixels SPX may be compensated based on a sensing signal output from the sensing circuit.

Although a case where the transistors M included in the pixel circuit PXC are all N-type transistors is illustrated in FIGS. 4 and 5, embodiments are not limited thereto. For example, at least one of the first, second, and third transistors M1, M2, and M3 may be changed to a P-type transistor. The structure and driving method of the sub-pixel SPX may be variously changed in some embodiments.

The light-emitting unit EMU may include at least one light-emitting element LD connected between the first power line PL1 and the second power line PL2. In one or more embodiments, the light-emitting element LD may include a first end portion EP1 electrically connected to the first power line PL1 through the pixel circuit PXC and a second end portion EP2 electrically connected to the second power line PL2.

The first power voltage VDD and a second power voltage VSS may be supplied to the light-emitting unit EMU respectively through the first power line PL1 and the second power line PL2. For example, the light-emitting unit EMU may be electrically connected to a power voltage generator through the first power line PL1 and the second power line PL2, and the first power voltage VDD and the second power voltage VSS, which are generated by the power voltage generator, may be supplied to the light-emitting unit EMU through the first power line PL1 and the second power line PL2, respectively. In one or more embodiments, the first power voltage VDD may be a high-potential power voltage, and the second power voltage VSS may be a low-potential power voltage.

In one or more embodiments, the first end portion EP1 of the light-emitting element LD may be a P-type end portion, and the second end portion EP2 of the light-emitting element LD may be an N-type end portion. For example, the light-emitting element LD may be connected in a forward direction between the first power line PL1 and the second power line PL2. Accordingly, the light-emitting element LD can constitute an effective light source of a corresponding sub-pixel SPX.

In one or more embodiments, as shown in FIG. 4, the light-emitting unit EMU may include a single light-emitting element LD connected in the forward direction between the first power line PL1 and the second power line PL2 (e.g., between the pixel circuit PXC and the second power line PL2). In one or more other embodiments, the light-emitting unit EMU may include two or more light-emitting elements LD connected in the forward direction between the first power line PL1 and the second power line PL2. For example, as shown in FIG. 5, the light-emitting unit EMU may include light-emitting elements LD connected in series-parallel to each other between the first power line PL1 and the second power line PL2. In one or more embodiments, the light-emitting unit EMU may include first and second serial stages, and may include at least one first light-emitting element LD1 located and/or connected in the first serial stage and at least one second light-emitting element LD2 located and/or connected in the second serial stage. The connection structure of light-emitting elements LD constituting each light-emitting unit EMU may be changed in some embodiments. For example, the light-emitting elements LD may be connected only in series or in parallel to each other between the first power line PL1 and the second power line PL2. The number, kind, and/or connection structure of a light-emitting element(s) constituting the effective light source of the sub-pixel SPX may be variously changed in some embodiments.

In one or more embodiments, each light-emitting element LD may be a rod-shaped inorganic light-emitting element. Also, each light-emitting element LD may be a subminiature light-emitting element having a size in a range of nanometers to micrometers. In one or more embodiments, the light-emitting element LD may be a light-emitting element LD in the one or more embodiments corresponding to FIGS. 1 and 2, but embodiments are not limited thereto. For example, the kind, material, structure, size, and/or shape of the light-emitting element LD may be variously changed in some embodiments.

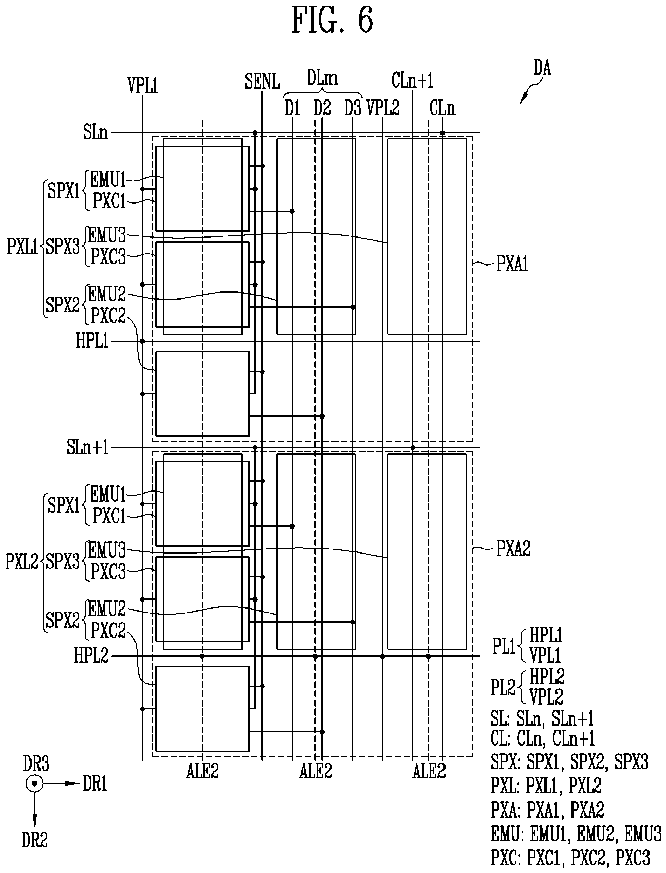

FIG. 6 is a plan view illustrating a display area DA in accordance with one or more embodiments of the present disclosure. In FIG. 6, based on a first pixel PXL1 and a second pixel PXL2, which are adjacent to each other along the second direction DR2 in the display area DA, the display area DA and a structure of pixels PXL located in the display area DA will be schematically illustrated. For example, the first pixel PXL1 may be located on an nth (n is a natural number) horizontal line (e.g., an nth pixel row) and an mth (m is a natural number) vertical line (e.g., an mth pixel column) of the display area DA, and the second pixel PXL2 may be located on an (n+1)th horizontal line (e.g., an (n+1)th pixel row) and the mth vertical line of the display area DA. The first pixel PXL1 and the second pixel PXL2 may be located on the same vertical line in the display area DA, and may be vertically adjacent to each other in the second direction DR2.

Referring to FIGS. 3 to 6, the display area DA may include pixels PXL including the first pixel PXL1 and the second pixel PXL2, and scan lines SL, data lines DL, sensing lines SENL, a first power line PL1, and a second power line PL2, which are electrically connected to the pixels PXL. In one or more embodiments, a control line SSL of each horizontal line may be integrated with a scan line SL of the corresponding horizontal line.

In one or more embodiments, the display area DA may further include connection lines crossing the scan lines SL and/or at least one dummy line. For example, the display area DA may include connection lines CL corresponding to the respective scan lines SL, and may selectively further include a dummy line and the like.

In one or more embodiments, connection lines CL each electrically connected to any one scan line SL and/or dummy lines separated from the connection lines CL may be located inside some pixel columns among pixel columns of the display area DA and/or at the periphery thereof. In one or more embodiments, the dummy lines may be used as sub-lines for reducing a resistance of the first power line PL1 and/or the second power line PL2. Dummy lines (or sub-power lines) each electrically connected to the first power line PL1 or the second power line PL2 may be located inside other pixel columns and/or at the periphery thereof.

The scan lines SL may extend in the first direction DR1 in the display area DA, and may be formed for every horizontal line. For example, the scan lines SL may include an nth scan line SLn located on the nth horizontal line of the display area DA or at the periphery thereof, and may include an (n+1)th scan line SLn+1 located on the (n+1)th horizontal line of the display area DA or at the periphery thereof. Each scan line SL may extend in the first direction DR1 in the display area DA, and may be electrically connected to pixel circuits PXC of sub-pixels SPX located on a corresponding horizontal line.

In one or more embodiments, each scan line SL may be electrically connected to at least one connection line CL, and may be electrically connected to a driving circuit DIC through the at least one connection line CL. For example, the nth scan line SLn may be electrically connected to an nth connection line CLn, and may be electrically connected to a driving circuit DIC through the nth connection line CLn and through a pad electrically connected thereto. Similarly, the (n+1)th scan line SLn+1 may be electrically connected to an (n+1)th connection line CLn+1, and may be electrically connected to a driving circuit DIC through the (n+1)th connection line CLn+1 and through a pad electrically connected thereto.

The connection lines CL may extend in the second direction DR2 in the display area DA, and may be formed on at least some vertical lines or at the periphery thereof. The connection lines CL may correspond to the respective scan lines SL, and may be electrically connected to the respective scan lines SL. For example, the connection lines CL may include the nth connection line CLn electrically connected to the nth scan line SLn, and the (n+1)th connection line CLn+1 electrically connected to the (n+1)th scan line SLn+1. The positions, size (e.g., width and/or length), and/or arrangement order of the connection lines CL may be changed in some embodiments.

The data lines DL may extend along the second direction DR2 in the display area DA, and may be formed for every vertical line. For example, an mth data line DLm may be formed on the mth vertical line of the display area DA. However, embodiments are not limited thereto. For example, the data lines DL may be formed for every two vertical lines adjacent to each other, and the two vertical lines may share data lines DL. Scan lines SL connected to pixels PXL of the two vertical lines are separated from each other, so that a time for which a data signal is input to the pixels PXL can be divided.

Each data line DL may be connected to pixel circuits PXC of sub-pixels SPX located on a corresponding vertical line. Also, each data line DL may include sub-data lines individually connected to sub-pixels SPX constituting each pixel PXL. For example, the mth data line DLm may include a first sub-data line D1 electrically connected to first sub-pixels SPX1 of pixels PXL located on the mth vertical line, a second sub-data D2 electrically connected to second sub-pixels SPX2 of the pixels PXL located on the mth vertical line, and a third sub-data line D3 electrically connected to third sub-pixels SPX3 of the pixels PXL located on the mth vertical line. Accordingly, a data signal can be individually supplied to each sub-pixel SPX.

The sensing line SENL may extend along the second direction DR2, and may be formed for every at least one vertical line. In one or more embodiments, the sensing lines SENL may be formed for every vertical line, and may be commonly connected to sub-pixels SPX constituting each pixel PXL. A characteristic of each pixel PXL may be individually detected. In one or more other embodiments, the sensing lines SENL may be formed such that a plurality of vertical lines share the sensing lines SENL. A characteristic of pixels PXL may be detected in a block unit including a plurality of pixels PXL.

The first power line PL1 and the second power line PL2 may be commonly connected to the pixels PXL of the display area DA. For example, the first power line PL1 may be commonly connected to pixel circuits PXC of sub-pixels SPX, and the second power line PL2 may be commonly connected to a light-emitting unit EMU (e.g., second alignment electrodes ALE2 of the light-emitting units EMU) of the sub-pixels SPX.

In one or more embodiments, each of the first power line PL1 and the second power line PL2 may be formed as a line having a mesh shape. Accordingly, a voltage drop (IR drop) of the first power voltage VDD and the second power voltage VSS can be prevented or reduced, and the first power voltage VDD and the second power voltage VSS, which respectively have a uniform level, can be transferred to the pixels PXL.

For example, the first power line PL1 may include at least one first horizontal power line HPL1 (also referred to as a "first lateral power line") extending in the first direction DR1 in the display area DA, and at least one first vertical power line VPL1 (also referred to as a "first longitudinal power line") that extends in the second direction DR2 in the display area and is electrically connected to the first horizontal power line HPL1. The at least one first horizontal power line HPL1 and the at least one first vertical power line VPL1 may cross each other, and may be connected to each other at all or some crossing points.

Similarly, the second power line PL2 may include at least one second horizontal power line HPL2 (also referred to as a "second lateral power line") extending in the first direction DR1 in the display area DA, and at least one second vertical power line VPL2 (also referred to as a "second longitudinal power line") that extends in the second direction DR2 in the display area and that is electrically connected to the second horizontal power line HPL2. The at least one second horizontal power line HPL2 and the at least one second vertical power line VPL2 may cross each other, and may be connected to each other at all or some crossing points.

In one or more embodiments, the first horizontal power line HPL1 and the second horizontal power line HPL2 may be formed for every one horizontal line or once for each of respective pluralities of horizontal lines. For example, the first horizontal power line HPL1 and the second horizontal power line HPL2 may be alternately arranged for every horizontal line. In one or more embodiments, the first horizontal power line HPL1 may be located on odd-numbered horizontal lines (or even-numbered horizontal lines), and the second horizontal power line HPL2 may be located on even-numbered horizontal lines (or odd-numbered horizontal lines).

In one or more embodiments, the first horizontal power line HPL1 and the second horizontal power line HPL2 may be immediately adjacent to emission areas (e.g., emission areas corresponding to respective light-emitting units EMU) provided in pixels PXL of a corresponding horizontal line. For example, the first horizontal power line HPL1 and the second horizontal power line HPL2 may be immediately adjacent to bottom edge areas of emission areas corresponding to light-emitting units EMU of the corresponding horizontal line, and may traverse pixel areas PXA in which the pixels of the corresponding horizontal line are located. In one or more embodiments, the first horizontal power line HPL1 may be located between second and third pixel circuits PXC2 and PXC3 (e.g., pixel circuits of second and third sub-pixels SPX2 and SPX3) that are provided in pixels PXL of odd-numbered horizontal lines (or even-numbered horizontal lines), and the second horizontal power line HPL2 may be located between second and third pixel circuits PXC2 and PXC3 (pixel circuits of second and third sub-pixels SPX2 and SPX3) that are provided in pixels PXL of even-numbered horizontal lines (or odd-numbered horizontal lines). In one or more embodiments, first and third pixel circuits PXC1 and PXC3 (pixel circuits of first and third sub-pixels SPX1 and SPX3) of pixels PXL provided on each horizontal line may be located between two lines that each extend in the first direction and are located at respective sides of emission areas corresponding to light-emitting units EMU of corresponding horizontal lines in the second direction DR2. In one or more embodiments, the first and third pixel circuits PXC1 and PXC3 provided in the pixels PXL of each horizontal line may be located between a scan line SL of the corresponding horizontal line and the first or second horizontal power line HPL1 or HPL2.

The number, positions, and/or arrangement structure of first and second horizontal power lines HPL1 and HPL2 may be variously changed in some embodiments.

In one or more embodiments, the first vertical power line VPL1 and the second vertical power line VPL2 may be formed for every at least one vertical line. For example, the first vertical power line VPL1 and the second vertical power line VPL2 may be formed for every vertical line (e.g., at the periphery thereof), and may be spaced apart from each other with pixel circuits PXC arranged on a pixel column of a corresponding vertical line, which are interposed therebetween. The number and/or positions of first and second vertical power lines VPL1 and VPL2 may be variously changed in some embodiments.

Each pixel PXL may include sub-pixels SPX. In one or more embodiments, each pixel PXL may include a first sub-pixel SPX1, a second sub-pixel SPX2, and a third sub-pixel SPX3.

Each sub-pixel SPX may include a pixel circuit PXC and a light-emitting unit EMU. For example, the first sub-pixel SPX1 may include a first pixel circuit PXC1 and a first light-emitting unit EMU1, and the second sub-pixel SPX2 may include a second pixel circuit PXC2 and a second light-emitting unit EMU2. The third sub-pixel SPX3 may include a third pixel circuit PXC3 and a third light-emitting unit EMU3.

Pixel circuits PXC and light-emitting units EMU of each pixel PXL may be located in different layers, and may overlap with each other. For example, the pixel circuits PXC may be located in a circuit layer (e.g., a pixel circuit PCL shown in FIG. 7) of a corresponding pixel area PXA in which each pixel PXL is located. The light-emitting units EMU may be located in a display layer (e.g., a display layer DPL shown in FIG. 7) of the corresponding pixel area PXA to overlap with at least one pixel circuit PXC (e.g., the first light-emitting unit EMU1 may overlap the first pixel circuit PXC1 and the third pixel circuit PXC3) among the pixel circuits PXC of the corresponding pixel PXL, and/or to overlap at least one line (e.g., at least one scan line SL, a sensing line SENL, a data line DL, a first power line PL1, a second power line PL2, and/or a connection line CL).

In FIG. 6, an area in which each pixel circuit PXC is located will be displayed based on an area in which main circuit elements (e.g., transistors M and a capacitor Cst), which constitute each pixel circuit or at least a portion of the circuit elements, are located. In some embodiments, another of the circuit elements may be located outside of the displayed area. Also, in FIG. 6, an area in which each light-emitting unit EMU is located will be displayed based on an area in which main components (e.g., electrodes electrically connected to the light-emitting elements LD) constituting each light-emitting unit EMU, or based on each emission area in which at least a portion of the main components is located. In some embodiments, at least another portion of the main elements (e.g. end portions of electrodes connected to the light-emitting elements LD) may be located at the outside of the display area.

The first, second, and third pixel circuits PXC1, PXC2, and PXC3 may be arranged in the second direction DR2 in each pixel area PXA. For example, the first, second, and third pixel circuits PXC1, PXC2, and PXC3 of the first pixel PXL1 may be arranged along the second direction DR2 in an order (e.g., a predetermined order) in a first pixel area PXA1 in which the first pixel PXL1 is provided. Similarly, the first, second, and third pixel circuits PXC1, PXC2, and PXC3 of the second pixel PXL2 may be arranged along the second direction DR2 in an order (e.g., a predetermined order) in a second pixel area PXA2 in which the second pixel PXL2 is provided.

In one or more embodiments, the third pixel circuit PXC3 may be located at the center of each pixel area PXA with respect to the second direction DR2, and the first and second pixel circuits PXC1 and PXC2 may be located at respective sides of the third pixel circuit PXC3 in the second direction DR2. For example, in each pixel area PXA, pixel circuits PXC may be arranged in an order of the first pixel circuit PXC1, the third pixel circuit PXC3, and the second pixel circuit PXC2 along the second direction DR2. The locations and/or arrangement order of the first, second, and third pixel circuits PXC1, PXC2, and PXC3 may be changed in some embodiments.

The first, second, and third pixel circuits PXC1, PXC2, and PXC3 may be commonly connected to the first power line PL1 and a scan line SL of a corresponding horizontal line, and may be connected to different sub-data lines of a corresponding vertical line. For example, the first pixel circuit PXC1 may be electrically connected to a first sub-data line D1, and the second pixel circuit PXC2 may be electrically connected to a second sub-data line D2. The third sub-pixel circuit PXC3 may be electrically connected to a third sub-data line D3.

In one or more embodiments, the first, second, and third pixel circuits PXC1, PXC2, and PXC3 may be further connected to a sensing line SENL. For example, first, second, and third pixel circuits PXC1, PXC2, and PXC3 may be commonly connected to a sensing line SENL of the corresponding vertical line.

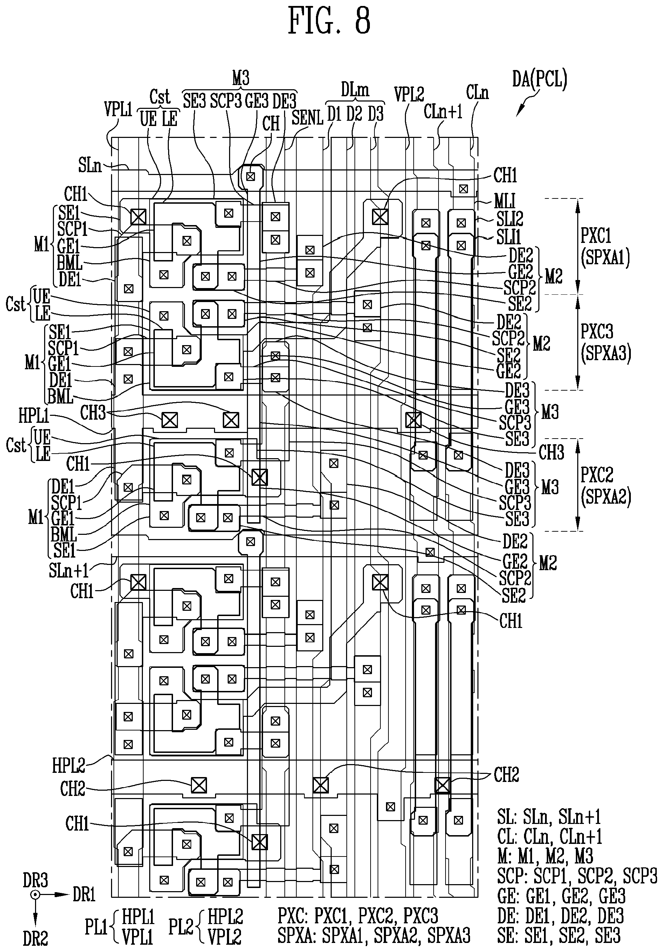

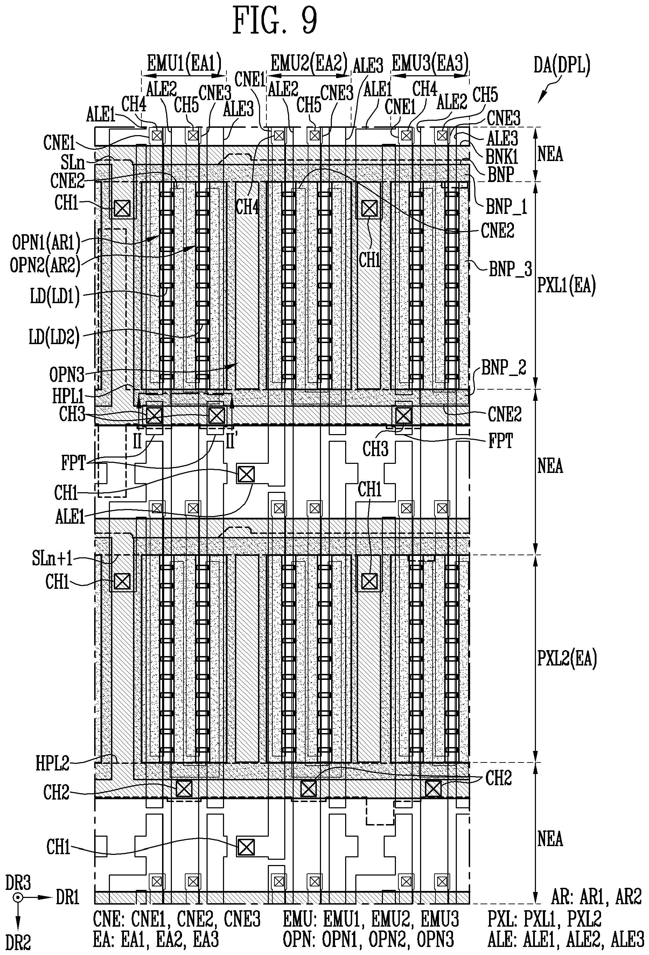

The first, second, and third light-emitting units EMU1, EMU2, and EMU3 may be connected between the respective pixel circuits PXC and the second power line PL2. For example, the first, second, and third light-emitting units EMU1, EMU2, and EMU3 may be electrically connected to the first, second, and third pixels PXC1, PXC2, and PXC3 through first contact holes (e.g., first contact holes CH1 shown in FIGS. 8 and 9), respectively. Also, the first, second, and third light-emitting units EMU1, EMU2, and EMU3 may be electrically connected to the second power line PL2 respectively through second contact holes (e.g., second contact holes CH2 shown in FIGS. 8 and 9).

The first, second, and third light-emitting units EMU1, EMU2, and EMU3 may be arranged in the first direction DR1 in each pixel area PXA. For example, first, second, and third light-emitting units EMU1, EMU2, and EMU3 of the first pixel PXL1 may be sequentially arranged along the first direction DR1 in a first pixel area PXA1 corresponding to the first pixel PXL1. Similarly, first, second, and third light-emitting units EMU1, EMU2, and EMU3 of the second pixel PXL2 may be sequentially arranged along the first direction DR1 in a second pixel area PXA2 corresponding to the second pixel PXL2. The first, second, and third sub-pixels SPX1, SPX2, and SPX3 may respectively have emission areas (e.g., first, second, and third emission areas EA1, EA2, and EA3 shown in FIG. 9) corresponding to respective areas (or one portion) of the first, second, and third light-emitting units EMU1, EMU2, and EMU3. Accordingly, the emission areas of the first, second, and third sub-pixels SPX1, SPX2, and SPX3 may be sequentially arranged along the second direction DR2. Therefore, it can be seen that, with respect to the emission areas of the first, second, and third sub-pixels SPX1, SPX2, and SPX3, the first, second, and third sub-pixels SPX1, SPX2, and SPX3 are arranged along the second direction DR2.

Although one or more embodiments in which pixel circuits PXC and light-emitting units EMU of sub-pixels SPX are arranged along different directions in each pixel area PXA has been disclosed in FIG. 6, embodiments are not limited thereto. For example, the positions and/or arrangement directions of the pixel circuits PXC and the light-emitting units EMU may be variously changed in some embodiments.

FIG. 7 is a sectional view illustrating a display area DA in accordance with one or more embodiments of the present disclosure. For example, FIG. 7 schematically illustrates a section of the display area DA, based on one sub-pixel SPX including a light-emitting unit EMU having a series-parallel structure (or serial structure) including first and second light-emitting elements LD1 and LD2 as shown in the one or more embodiments corresponding to FIG. 5.

Sub-pixels SPX located in the display area DA may have sectional structures substantially identical or similar to each other. However, the sizes, positions, and/or shapes of circuit elements constituting the sub-pixels SPX and electrodes included in the circuit elements may be different from each other according to the sub-pixels SPX. For example, when viewed on a plane, a first transistor M1 of a first sub-pixel SPX1 may have a shape and/or a size that is different from a shape and/or a size of a first transistor M1 of a second sub-pixel SPX2.

Referring to FIGS. 1 to 7, the display device DD may include a base layer BSL, a circuit layer PCL (also referred to as a "circuit element layer," a "pixel circuit layer," or a "backplane"), and a display layer DPL (also referred to as a "display element layer" or a "light-emitting element layer"). The circuit layer PCL and the display layer DPL may overlap with each other on the base layer BSL. In one or more embodiments, the circuit layer PCL and the display layer DPL may be sequentially located on one surface of the base layer BSL.

The display device DD may further include a color filter layer CFL and/or an encapsulation layer ENC (or protective layer) located on (e.g., above) the display layer DPL. In one or more embodiments, the color filter layer CFL and the encapsulation layer ENC may be formed directly on the one surface of the base layer BSL on which the circuit layer PCL and the display layer DPL are formed. Accordingly, the thickness of the display device DD can be reduced.

The base layer BSL may be a substrate or a film, which is made of a rigid or flexible material. In one or more embodiments, the base layer BSL may include at least one insulating material, and may have a single-layer structure or a multilayer structure.

The circuit layer PCL may be provided on the one surface of the base layer BSL. The circuit layer PCL may include pixel circuits PXC of each pixel PXL. For example, circuit elements (e.g., transistors M and capacitors Cst) constituting first, second, and third pixel circuits PXC1, PXC2, and PXC3 of a corresponding pixel PXL may be formed in each pixel area PXA of the circuit layer PCL. In FIG. 7, a section of any one transistor M (e.g., a first transistor M1 including a bottom metal layer BML) provided in each pixel circuit PXC will be schematically illustrated as an example of circuit elements that may be located in the circuit layer PCL of the display area DA.

Also, the circuit layer PCL may include signal lines and power lines, which are connected to the pixels PXL. For example, the circuit layer PCL may include scan lines SL, data lines DL, sensing lines SENL, a first power line PL1, and a second power line PL2. In one or more embodiments, the circuit layer PCL may further include connection lines CL and/or dummy lines.

In one or more embodiments, some lines (or portions of the lines) provided in the circuit layer PCL may be located in the same layer as some components or electrodes of transistors M. Other lines (or portions of the lines) provided in the circuit layer PCL may be located in the same layer as other components or electrodes of the transistors M.

The circuit layer PCL may include conductive layers including electrodes, conductive patterns and/or bridge patterns, and lines of circuit elements. For example, the circuit layer PCL may include conductive layers (e.g., first, second, and third conductive layers) sequentially located on the base layer BSL along the third direction DR3. The conductive layers may respectively include electrodes, conductive patterns, bridge patterns, and/or lines. The circuit layer PCL may further include a semiconductor layer including semiconductor patterns SCP of the transistors M.

The circuit layer PCL may further include insulating layers. For example, the circuit layer PCL may include a buffer layer BFL, a gate insulating layer GI, an interlayer insulating layer ILD, and/or a passivation layer PSV, which are sequentially located on the one surface of the base layer BSL.

The circuit layer PCL may include a first conductive layer located on the base layer BSL. In one or more embodiments, the first conductive layer may be located between the base layer BSL and the buffer layer BFL, and may include bottom metal layers BML of first transistors M1 included in the sub-pixels SPX. Each bottom metal layer BML may overlap with a semiconductor pattern SCP of a first transistor corresponding thereto.

The first conductive layer may further include at least one line. For example, the first conductive layer may include lines (or portions of the lines) extending in the second direction DR2 in the display area DA. In one or more embodiments, the first conductive layer may include data lines DL, sensing lines SENL, first vertical power lines VPL1, second vertical power lines VPL2, and/or connection lines CL.

The buffer layer BFL may be located on the one surface of the base layer BSL including the first conductive layer. The buffer layer BFL may reduce or prevent the likelihood of an impurity being diffused into each circuit element.

A semiconductor layer may be located on the buffer layer BFL. The semiconductor layer may include semiconductor patterns SCP of the transistors M. Each semiconductor pattern SCP may include a channel region overlapping with a gate electrode GE of a corresponding transistor M, and first and second conductive regions (e.g., source and drain regions) located at respective sides of the channel region.

The gate insulating layer GI may be located on the semiconductor layer. A second conductive layer may be located on the gate insulating layer GI.

The second conductive layer may include gate electrodes GE of the transistors M. The second conductive layer may further include one electrode (e.g., a lower electrode) of each of capacitors Cst provided in the pixel circuits PXC. Additionally, when at least one power line (e.g., a first vertical power line VPL1 and/or a second vertical power line VPL2) and/or at least one signal line (e.g., connection lines CL), located in the display area DA, are/is configured as a multilayer, the second conductive layer may further include at least one conductive pattern (e.g., first sub-lines SLI1 shown in FIG. 8) constituting the at least one power line and/or the at least one signal line.

The interlayer insulating layer ILD may be located over the second conductive layer. A third conductive layer may be located on the interlayer insulating layer ILD.

The third conductive layer may include source electrodes SE and drain electrodes DE of the transistors M. Each source electrode SE may be respectively connected to one region (e.g., the source region) of a semiconductor pattern SCP included in a corresponding transistor M through at least one contact hole CH, and each drain electrode DE may be connected to another area (e.g., the drain region) of the semiconductor pattern SCP included in the corresponding transistor M through at least another contact hole CH.

The third conductive layer may further include one electrode (e.g., an upper electrode) of each of the capacitors Cst provided in the pixel circuits PXC, at least one line, and/or at least one bridge pattern. For example, the third conductive layer may include lines (or portions of the lines) extending in the first direction DR1 in the display area DA. In one or more embodiments, the third conductive layer may include scan lines SL, first horizontal power lines HPL1, and second horizontal power lines HPL2. Additionally, when at least one power line (e.g., a first vertical power line VPL1 and/or a second vertical power line VPL2) and/or at least one signal line (e.g., connection lines CL), which may be located in the display area DA, are/is configured as a multilayer, the third conductive layer may further include at least one conductive pattern (e.g., second sub-lines SLI2 shown in FIG. 8) constituting the at least one power line and/or the at least one signal line.

Each of the electrodes, the conductive patterns, and/or the lines, which constitute the first to third conductive layers, may include a conductive material, thereby having conductivity, and the material constituting each of the conductive patterns, the electrodes, and/or the lines is not particularly limited. In one or more embodiments, each of the conductive patterns, the electrodes, and/or the lines, which respectively constitute the first to third conductive layers, may include at least one metal selected from molybdenum (Mo), aluminium (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu). Besides, each of the conductive patterns, the electrodes, and/or the lines, which respectively constitute the first to third conductive layers, may include various kinds of conductive materials.

The passivation layer PSV may be located over the third conductive layer. Each of the buffer layer BFL, the gate insulating layer GI, the interlayer insulating layer ILD, and the passivation layer PSV may be configured as a single layer or a multilayer, and may include an inorganic insulating material and/or an organic insulating material. For example, each of the buffer layer BFL, the gate insulating layer GI, the interlayer insulating layer ILD, and the passivation layer PSV may include silicon nitride (SiNₓ), silicon oxide (SiOₓ), silicon oxynitride (SiOₓN_{y}), or another insulating material. Although a case where the insulating layers of the circuit layer PCL (e.g., the buffer layer BFL, the gate insulating layer GI, the interlayer insulating layer ILD, and the passivation layer PSV) are substantially flat is illustrated in FIG. 7, each insulating layer may have a bending (e.g., an uneven surface) corresponding to a step difference occurring due to a lower conductive pattern and/or a lower insulating pattern.

In one or more embodiments, the passivation layer PSV may include an organic insulating layer, and may substantially planarize a surface of the circuit layer PCL. However, the passivation layer PSV may have a slight bending corresponding to patterns (e.g., electrodes, conductive patterns, and/or lines, which are included in the third conductive layer) located thereunder. Accordingly, the passivation layer PSV may have a height difference caused by the lower patterns.

The display layer DPL may be located on the passivation layer PSV. The display layer DPL may include light-emitting units EMU of each pixel PXL. For example, light-emitting elements LD constituting first, second, and third light-emitting units EMU1, EMU2, and EMU3, and electrodes connected thereto (e.g., at least one pair of alignment electrodes ALE and at least one pair of contact electrodes CNE, which are provided in each light-emitting unit EMU), may be formed in each pixel area PXA of the display layer DPL.

In one or more embodiments, the display layer DPL may include a first alignment electrode ALE1, a second alignment electrode ALE2, at least one first light-emitting element LD1, a first contact electrode CNE1, and a second contact electrode CNE2, which are located in an emission area of each sub-pixel SPX to constitute a light-emitting unit EMU of the corresponding sub-pixel SPX. In one or more embodiments, each light-emitting unit EMU may further include a third alignment electrode ALE3, at least one second light-emitting element LD2, and a third contact electrode CNE3, which are additionally provided in each emission area EA of the display layer DPL.

The display layer DPL may further include insulating layers and/or insulating patterns, which are sequentially located on the one surface of the base layer BSL on which the circuit layer PCL is formed. For example, the display layer DPL may include bank patterns BNP, a first insulating layer INS1, a first bank BNK1, a second insulating layer INS2, a third insulating layer INS3, and/or a fourth insulating layer INS4, which are sequentially located on the circuit layer PCL. In one or more embodiments, the display layer DPL may further include a second bank BNK2 and a light conversion layer CCL.

The bank patterns BNP (also referred to as "patterns" or "wall patterns") may be provided and/or formed on the passivation layer PSV. The bank patterns BNP may be located on the bottom of alignment electrodes ALE to overlap with a portion of each of the alignment electrodes ALE.

In one or more embodiments, the bank patterns BNP may be formed as separated patterns individually located corresponding to each pixel PXL. For example, in each pixel area PXA, bank patterns BNP corresponding to sub-pixels SPX of a corresponding pixel PXL may be integrally formed to be substantially formed as one bank pattern BNP. A bank pattern BNP corresponding to each pixel PXL may be considered as a component included in the corresponding pixel PXL (or light-emitting units EMU provided in the pixel PXL), or may be considered as a component to be provided in the pixel PXL separately from the pixel PXL.

In one or more other embodiments, bank patterns BNP corresponding to at least two adjacent pixels PXL may be integrally formed, to be substantially formed as one bank pattern BNP. For example, bank patterns BNP corresponding to pixels PXL that are located on each horizontal line and that are arranged in the first direction DR1 may be integrally formed. A portion of a bank pattern BNP corresponding to each pixel PXL may be considered as a component included in the corresponding pixel PXL (or light-emitting units EMU provided in the pixel PXL), or may be considered as a component to be provided in the pixel PXL separately from the pixel PXL.

Each bank pattern BNP may include openings OPN corresponding to light-emitting element arrangement areas AR of sub-pixels SPX provided in a corresponding pixel(s) PXL. For example, the bank pattern BNP may include first openings OPN1 corresponding to first light-emitting element arrangement areas AR1 in which first light-emitting elements LD1 of first, second, and third sub-pixels SPX1, SPX2, and SPX3 provided in the corresponding pixel(s) PXL are located, and/or second openings OPN2 corresponding to second light-emitting element arrangement areas AR2 in when second light-emitting elements LD2 of the first, second, and third sub-pixels SPX1, SPX2, and SPX3 are located.

By the bank patterns BNP, alignment electrodes ALE may protrude in an upper direction (e.g., the third direction DR3) at the periphery of light-emitting elements LD. The bank patterns BNP and the alignment electrodes ALE may form reflective protrusion patterns at the periphery of the light-emitting elements LD. Accordingly, the light efficiency of the sub-pixels SPX can be improved.

The bank patterns BNP may include an inorganic insulating material and/or an organic insulating material, and may have a single-layer structure or a multilayer structure. In one or more embodiments, the bank patterns BNP may be an organic layer pattern including an organic insulating material, and upper surfaces of the bank patterns BNP may be substantially flat. However, when the surface of the circuit layer PCL has a bending (e.g., an uneven shape), the bank patterns BNP may have a slight bending corresponding to the bending of the circuit layer PCL. For example, the bank patterns BNP may be formed to be relatively high at a portion at which the surface of the circuit layer PCL has a maximum height.

Alignment electrodes ALE of light-emitting units EMU may be located over the bank patterns BNP.

The alignment electrodes ALE may include a conductive material, and the material constituting the alignment electrodes ALE is not particularly limited. In one or more embodiments, the alignment electrodes ALE may include at least one metal or any alloy including the same among various metallic materials including silver (Ag), magnesium (Mg), aluminium (Al), platinum (Pt), palladium (Pd), gold (Au), nickel (Ni), neodymium (Nd), iridium (Ir), chromium (Cr), titanium (Ti), molybdenum (Mo), copper (Cu), and the like, a conductive oxide such as Indium Tin Oxide (ITO), Indium Zinc Oxide (IZO), Indium Tin Zinc Oxide (ITZO), Zinc Oxide (ZnO), Aluminium doped Zinc Oxide (AZO), Gallium doped Zinc Oxide (GZO), Zinc Tin Oxide (ZTO), Gallium Tin Oxide (GTO), and Fluorine doped Tin Oxide (FTO), at least one conductive material among conductive polymers such as PEDOT, carbon nano tubes, graphene, and/or another conductive material.

The first alignment electrode ALE1 and the second alignment electrode ALE2 may be adjacent to each other, and may be spaced apart from each other. For example, the first alignment electrode ALE1 and the second alignment electrode ALE2 may be adjacent to each other in the first direction DR1, and may be spaced apart from each other in the first direction DR1. At least one first light-emitting element LD1 may be located between the first alignment electrode ALE1 and the second alignment electrode ALE2 (or in a first light-emitting element arrangement area AR1 corresponding thereto).

The second alignment electrode ALE2 and the third alignment electrode ALE3 may be adjacent to each other, and may be spaced apart from each other. For example, the second alignment electrode ALE2 and the third alignment electrode ALE3 may be adjacent to each other in the first direction DR1, and may be spaced apart from each other in the first direction DR1. In one or more embodiments, in an emission area EA of each sub-pixel SPX, the first alignment electrode ALE1, the second alignment electrode ALE2, and the third alignment electrode ALE3 may be sequentially located along the first direction DR1. At least one second light-emitting element LD2 may be located between the second alignment electrode ALE2 and the third alignment electrode ALE3 (or in a second light-emitting element arrangement area AR2 corresponding thereto). The number, shapes, sizes, and/or positions of alignment electrodes ALE located in each emission area EA may be changed in some embodiments.

Each of the alignment electrodes ALE may be a single layer or a multilayer. In one or more embodiments, each alignment electrode ALE may include a reflective electrode layer including a reflective conductive material (e.g., a metal), and a single-layer electrode or a multilayer electrode.

The first insulating layer INS1 may be located on the alignment electrodes ALE. In one or more embodiments, the first insulating layer INS1 may include contact holes (e.g., fourth and fifth contact holes CH4 and CH5 shown in FIG. 9) for electrically connecting at least some alignment electrodes ALE (e.g., the first and second alignment electrodes ALE1 and ALE2) respectively to contact electrodes CNE (e.g., first and third contact electrodes CNE1 and CNE3) corresponding thereto.

The first insulating layer INS1 may be a single layer or a multilayer, and may include an inorganic insulating material and/or an organic insulating material. In one or more embodiments, the first insulating layer INS1 may include silicon nitride (SiNₓ), silicon oxide (SiOₓ), silicon oxynitride (SiOₓN_{y}), or another insulating material.

As the alignment electrodes ALE are covered by the first insulating layer INS1, the likelihood of the alignment electrodes ALE being damaged in a subsequent process can be reduced or prevented. In addition, the likelihood of a short-circuit defect as alignment electrodes ALE and light-emitting elements LD are inappropriately connected to each other can be reduced or prevented.

The first bank BNK1 may be located in the display area DA in which the alignment electrodes ALE and the first insulating layer INS1 are formed. The first bank BNK1 may have openings corresponding to emission areas EA of sub-pixels SPX, and may be formed in a non-emission area NEA to surround the emission areas EA of the sub-pixels SPX. Each emission area EA to which light-emitting elements LD are to be supplied may be defined (or partitioned) by the first bank BNK1.

In one or more embodiments, the first bank BNK1 may include a black matrix material, or another light-blocking material and/or a reflective material in addition to the black matrix material. The first bank BNK1 may include an inorganic insulating material and/or an organic insulating material, and may have a single-layer structure or a multilayer structure. In one or more embodiments, the first bank BNK1 may be an organic layer pattern including an organic insulating material, and may have a relatively gentle bending (e.g., a slight unevenness). In one or more embodiments, the first bank BNK1 may have partially different heights respectively due to patterns located thereunder. In one or more embodiments, a portion of the first bank BNK1, which overlaps with the bank patterns BNP, may be relatively higher than the other portion of the first bank BNK1.

Light emitting elements LD may be supplied to each emission area EA surrounded by the first bank BNK1. The light-emitting elements LD may be located and/or aligned between a pair of alignment electrodes ALE by alignment signals respectively applied to alignment electrodes ALE (e.g., a first alignment line, a second alignment line, and/or a third alignment line before the alignment electrodes ALE are separated into a first alignment electrode ALE1, a second alignment electrode ALE2, and/or a third alignment electrode ALE3 of each pixel PXL or each sub-pixel SPX). For example, the light-emitting elements LD supplied to each emission area EA may be respectively located and/or aligned between the first alignment electrode ALE1 and the second alignment electrode ALE2, and between the second alignment electrode ALE2 and the third alignment electrode ALE3.

In one or more embodiments, a first light-emitting element(s) LD1 located and/or aligned in a first light-emitting element arrangement area AR1 between the first alignment electrode ALE1 and the second alignment electrode ALE2 may be arranged in the first direction DR1, an oblique direction, or the like such that a first end portion(s) of the first light-emitting element(s) LD1 is/are adjacent to the first alignment electrode ALE1 and such that a second end portion(s) of the first light-emitting element(s) LD1 is/are adjacent to the second alignment electrode ALE2.

A second light-emitting element(s) LD2 located and/or aligned in a second light-emitting element arrangement area AR2 between the second alignment electrode ALE2 and the third alignment electrode ALE3 may be arranged in the first direction DR1, an oblique direction, or the like such that a first end portion(s) of the second light-emitting element(s) LD2 is/are adjacent to the third alignment electrode ALE3, and such that a second end portion(s) of the second light-emitting element(s) LD2 is/are adjacent to the second alignment electrode ALE2. The arrangement positions and/or direction of light-emitting elements LD may be changed in some embodiments.

The second insulating layer INS2 may be located on a portion of each of the light-emitting elements LD. In one or more embodiments, the second insulating layer INS2 is entirely formed in the display area DA, and may include openings opened at first and second end portions EP1 and EP2 of light-emitting elements LD aligned in an emission area EA of a corresponding sub-pixel SPX and the periphery thereof (e.g., an area corresponding to alignment electrodes ALE and/or contact electrodes CNE). In one or more other embodiments, the second insulating layer INS2 may include separated insulating patterns locally located only on a portion including central portions of light-emitting elements LD aligned in each emission area EA (or each light-emitting element arrangement area AR provided in the emission area EA) to expose first and second end portions EP1 and EP2 of the light-emitting element LD. When the second insulating layer INS2 is formed on the top of light-emitting elements LD, the light-emitting elements LD can be stably fixed.

The second insulating layer INS2 may be a single layer or a multilayer, and may include an inorganic insulating material and/or an organic insulating material. For example, the second insulating layers INS2 may include silicon nitride (SiNₓ), silicon oxide (SiOₓ), silicon oxynitride (SiOₓN_{y}), aluminium oxide (AlₓO_{y}), a photoresist material, or another insulating material.

Different contact electrodes CNE may be located and/or formed on first and second end portions EP1 and EP2 of light-emitting elements LD that are not covered by the second insulating layer INS2. For example, the first contact electrode CNE1 may be located on a first end portion EP1 of the first light-emitting element LD1, and a portion of the second contact electrode CNE2 (e.g., a left pattern portion of the second contact electrode CNE2) may be located on a second end portion EP2 of the first light-emitting element LD1. Another portion of the second contact electrode CNE2 (e.g., a right pattern portion of the second contact electrode CNE2) may be located on a first end portion EP1 of the second light-emitting element LD2, and the third contact electrode CNE3 may be located on a second end portion EP2 of the second light-emitting element LD2.

Although a case where the second contact electrode CNE2 located on the second end portion EP2 of the first light-emitting element LD1, and the second contact electrode CNE2 located on the first end portion EP1 of the second light-emitting element LD2, are separated from each other is illustrated in FIG. 7, the second contact electrode CNE2 located on the second end portion EP2 of the first light-emitting element LD1, and the second contact electrode CNE2 located on the first end portion EP1 of the second light-emitting element LD2, may be integrally or non-integrally connected to each other to thereby constitute one second contact electrode CNE2. For example, when viewed on a plane, the second contact electrode CNE2 located on the second end portion EP2 of the first light-emitting element LD1, and the second contact electrode CNE2 located on the first end portion EP1 of the second light-emitting element LD2, may be integrally connected to each other. The second contact electrode CNE2 may be electrically connected to the first contact electrode CNE1 via the first light-emitting element LD1, and may be electrically connected to the third contact electrode CNE3 via the second light-emitting element LD2.

In one or more embodiments, the first contact electrode CNE1 may be directly formed on the first end portion EP1 of the first light-emitting element LD1, to be electrically connected to the first end portion EP1 of the first light-emitting element LD1. The second contact electrode CNE2 may be directly formed on the second end portion EP2 of the first light-emitting element LD1 and on the first end portion EP1 of the second light-emitting element LD2 to be electrically connected to the second end portion EP2 of the first light-emitting element LD1 and to the first end portion EP1 of the second light-emitting element LD2. The third contact electrode CNE3 may be directly formed on the second end portion EP2 of the second light-emitting element LD2 to be electrically connected to the second end portion EP2 of the second light-emitting element LD2. Meanwhile, when each sub-pixel SPX includes only a single light-emitting element LD as illustrated in the one or more embodiments corresponding to FIG. 4, or when each sub-pixel SPX includes a light-emitting unit EMU having a parallel structure, the sub-pixel SPX may include only a pair of contact electrodes CNE respectively located on first end portions EP1 and on second end portions EP2 of light-emitting elements LD.

The first contact electrode CNE1 may be located on the top of the first alignment electrode ALE1 to overlap with the first alignment electrode ALE1. The second contact electrode CNE2 may be located on the top of the second alignment electrode ALE2 and the third alignment electrode ALE3 to overlap with a portion of the second alignment electrode ALE2 and the third alignment electrode ALE3. The third contact electrode CNE3 may be on the top of the second alignment electrode ALE2 to overlap with another portion of the second alignment electrode ALE2.

In one or more embodiments, the first alignment electrode ALE1 and the first contact electrode CNE1 may be electrically connected to each other through at least one contact hole (e.g., a fourth contact hole CH4 shown in FIG. 9). Similarly, the second alignment electrodes ALE2 and the third contact electrode CNE3 may be electrically connected to each other through at least another contact hole (e.g., a fifth contact hole CH5 shown in FIG. 9). A first alignment electrode ALE1 and/or a first contact electrode CNE1 of each sub-pixel SPX may be electrically connected to a pixel circuit PXC of the corresponding sub-pixel SPX through at least one contact hole (e.g., a first contact hole CH1 shown in FIGS. 8 and 9). Second alignment electrodes ALE2 and/or a third contact electrode CNE3 of each sub-pixel SPX may be electrically connected to the second power line PL2 through at least another contact hole (e.g., a second contact hole CH2 shown in FIGS. 8 and 9).

The contact electrodes CNE may include a conductive material. In one or more embodiments, the contact electrodes CNE may include a transparent conductive material to allow light generated from light-emitting elements LD to be transmitted therethrough. For example, the contact electrodes CNE may include at least one conductive material among indium tin oxide (ITO), indium zinc oxide (IZO), indium tin zinc oxide (ITZO), zinc oxide (ZnO) or indium oxide (In₂O₃), or another transparent conductive material.

The first contact electrode CNE1, the second contact electrode CNE2, and/or the third contact electrode CNE3 may be formed in the same layer or in different layers. For example, the mutual positions and/or formation order of the first contact electrode CNE1, the second contact electrode CNE2, and the third contact electrode CNE3 may be variously changed in some embodiments.

In one or more embodiments, the first contact CNE1 and the third contact electrode CNE3 may be first formed on the second insulating layer INS2. The first contact CNE1 and the third contact electrode CNE3 may be concurrently/substantially simultaneously or sequentially formed. Subsequently, the third insulating layer INS3 may be formed to cover the first contact CNE1 and the third contact electrode CNE3, and the second contact electrode CNE2 may be formed in each emission area EA in which the third insulating layer INS3 is formed.

In one or more other embodiments, the second contact electrode CNE2 may be first formed on the second insulating layer INS2. Subsequently, the third insulating layer INS3 may be formed in each emission area EA to cover at least the second contact electrode CNE2, and the first contact electrode CNE1 and the third contact electrode CNE3 may be formed each emission area EA in which the third insulating layer INS3 is formed. The first contact electrode CNE1 and the third contact electrode CNE3 may be concurrently/substantially simultaneously or sequentially formed.

In one or more embodiments, the third insulating layer INS3 is entirely formed in the display area DA, and may include/define openings opened in an area corresponding to second contact electrodes CNE2 of sub-pixels SPX (or first and third contact electrodes CNE1 and CNE3 of the sub-pixels SPX). In one or more other embodiments, the third insulating layer INS3 may include separated insulating patterns individually formed for each emission area EA to cover first and third contact electrodes CNE1 and CNE3 (or a second contact electrode CNE2) formed in each emission area EA.

The third insulating layer INS3 may be a single layer or a multilayer, and may include an inorganic insulating material and/or an organic insulating material. For example, the third insulating layer INS3 may include silicon nitride (SiNₓ), silicon oxide (SiOₓ), silicon oxynitride (SiOₓN_{y}), aluminium oxide (AlₓO_{y}), a photoresist material, or another insulating material. The first insulating layer INS1, the second insulating layer INS2, and/or the third insulating layer INS3 may include the same insulating material or include different insulating materials.

When contact electrodes CNE (e.g., first and second contact electrodes CNE1 and CNE2, or second and third contact electrodes CNE2 and CNE3) located on first and second end portions EP1 and EP2 of respective light-emitting elements LD are located in different layers by using the third insulating layer INS3, the contact electrodes CNE can be stably separated from each other, and the likelihood of a short-circuit defect can be prevented or reduced.

In some embodiments, the first contact electrode CNE1, the second contact electrode CNE2, and the third contact electrode CNE3 may be located in the same layer of the display layer DPL, and may be concurrently/substantially simultaneously or sequentially formed. The display area DA may not include the third insulating layer INS3. When the contact electrodes CNE are concurrently/substantially simultaneously formed in the same layer, a pixel process can be simplified, and manufacturing efficiency can be improved.

In one or more embodiments, the display device DD may further include the light conversion layer CCL and the second bank BNK2, which are provided above the light-emitting elements LD. The color conversion layer CCL may be located in each emission area EA in which the light-emitting elements LD are located. The second bank BNK2 may be located in the non-emission area NEA to overlap with the first bank BNK1.

The second bank BNK2 may define (or partition) each emission area EA in which the light conversion layer CCL is to be formed. In one or more embodiments, the second bank BNK2 may be integrated with the first bank BNK1.

The second bank BNK2 may include a black matrix material, or another light-blocking material, and/or a reflective material in addition to the black matrix material. The second bank BNK2 may include the same material as the first bank BNK1, or may include a material different from the material of the first bank BNK1.

The light conversion layer CCL may include light conversion particles LCP corresponding to each sub-pixel SPX. The light conversion particles LCP may include wavelength conversion particles (or color conversion particles) for converting a wavelength and/or a color of light emitted from light-emitting elements LD located in a corresponding emission area EA, and/or light-scattering particles for improving light emission efficiency by scattering light emitted from the light-emitting elements LD. In one or more embodiments, each light conversion layer CCL including wavelength conversion particles including at least one kind of quantum dot (e.g., a red quantum dot, a green quantum dot, and/or a blue quantum dot) and/or light-scattering particles SCT may be provided on a light-emitting unit EMU of each sub-pixel SPX.

For example, when a sub-pixel SPX is set as a red (or green) sub-pixel, and blue light-emitting elements LD are provided to a light-emitting unit EMU of the sub-pixel SPX, a color conversion layer CCL including a red (or green) quantum dot for converting blue light into red (or green) light may be located on the light-emitting unit EMU of the sub-pixel SPX. In one or more embodiments, the light conversion layer CCL may further include light-scattering particles. When a sub-pixel SPX is set as a blue sub-pixel, and blue light-emitting elements LD are provided to a light-emitting unit EMU of the sub-pixel SPX, a color conversion layer CCL including light-scattering particles may be provided on the light-emitting unit EMU of the sub-pixel SPX, or the light conversion layer CCL may be omitted.

The fourth insulating layer INS4 may be formed on the one surface of the base layer BSL including light-emitting units EMU and/or light conversion layers CCL of the sub-pixels SPX.

The fourth insulating layer INS4 may be a single layer or a multilayer, and may include an organic insulating material and/or an inorganic insulating material. The fourth insulating layer INS4 may protect the light-emitting units EMU and/or the light conversion layers CCL. In one or more embodiments, the fourth insulating layer INS4 may include an organic layer including an organic insulating material, and may planarize a surface of the display layer DPL.

The color filter layer CFL may be located on the fourth insulating layer INS4. The color filter layer CFL may include color filters CF corresponding to a color of sub-pixels SPX. For example, the color filter layer CFL may include a first color filter CF1 located in the emission area EA of the first sub-pixel SPX1, a second color filter CF2 located in the emission area EA of the second sub-pixel SPX2, and a third color filter CF3 located in the emission area EA of the third sub-pixel SPX3. Each color filter CF may be provided on a light-emitting unit EMU of a corresponding sub-pixel SPX to overlap with the light-emitting unit EMU.

In one or more embodiments, the first, second, and third color filters CF1, CF2, and CF3 may overlap with each other in the non-emission area NEA, and accordingly, light can be blocked from being transmitted through the non-emission area NEA. In one or more other embodiments, the first, second, and third color filters CF1, CF2, and CF3 may be formed in emission areas EA of the sub-pixels SPX to be separated from each other, and a separate light blocking pattern or the like may be located between the first, second, and third color filters CF1, CF2, and CF3.

The encapsulation layer ENC may be located on the color filter layer CFL. The encapsulation layer ENC may include a fifth insulating layer INS5. The fifth insulating layer INS5 may be a single layer or a multilayer, and may include an organic insulating material and/or an inorganic insulating material. In one or more embodiments, the fifth insulating layer INS5 may be entirely formed in at least the display area DA to cover the circuit layer PCL, the display layer DPL, and/or the color filter layer CFL, and planarize a surface of the display panel DPN. In one or more other embodiments, the display panel DPN may be manufactured not to include the encapsulation layer ENC, and a protective film and the like, which are separately manufactured, may be attached onto the display panel DPN.

FIG. 8 is a plan view illustrating a circuit layer PCL of the display area DA in accordance with one or more embodiments of the present disclosure. For example, FIG. 8 illustrates one or more embodiments of a structure of the circuit layer PCL, based on an area in which pixel circuits PXC of the first pixel PXL1 and the second pixel PXL2 (shown in FIG. 6), and in which lines at the periphery thereof, are located.

In one or more embodiments, the pixels PXL including the first pixel PXL1 and the second pixel PXL2, which are located in the display area DA, may have structures that are substantially similar or identical to one another. Accordingly, in FIG. 8, a structure of pixel circuits PXC provided in each pixel PXL will be described based on circuit elements constituting first, second, and third pixel circuits PXC1, PXC2, and PXC3 of the first pixel PXL1.

Referring to FIGS. 3 to 8, the circuit layer PCL may include pixel circuits PXC of sub-pixels SPX located in each pixel area PXA. For example, the circuit layer PCL may include a first pixel circuit PXC1, a second pixel circuit PXC2, and a third pixel circuit PXC3 respectively located a first circuit area SPXA1, a second circuit area SPXA2, and a third circuit area SPXA3 of a corresponding pixel area PXA.

The circuit layer PCL may further include lines electrically connected to the pixels PXL. For example, the circuit layer PXL may include scan lines SL, data lines DL, sensing lines SENL, a first power line PL1 (e.g., a mesh-shaped first power line PL1 including first horizontal power lines HPL1 and first vertical power lines VPL1), and a second power line PL2 (e.g., a mesh-shaped second power line PL2 including second horizontal power lines HPL2 and second vertical power lines VPL2). In one or more embodiments, the circuit layer PCL may further include connection lines CL electrically connected to the scan lines SL. The arrangement structure, extending direction, and/or positions on a section of the scan lines SL, the data lines DL, the sensing lines SENL, the first power line PL1, the second power line PL2, and the connection lines CL have been in the embodiments shown in FIGS. 6 and 7, and therefore, overlapping descriptions will be omitted.

The circuit layer PCL may further include contact holes CH for electrically connecting circuit elements, electrodes, conductive patterns, and/or lines, which are located in the circuit layer PCL, to each other. In FIG. 8, a reference numeral may be given to only one contact hole CH (e.g., a contact hole CH for electrically connecting an nth scan line and gate electrodes GE of second and third transistors M2 and M3 to each other) representing contact holes CH for connecting corresponding components in the circuit layer PCL.

In one or more embodiments, at least one line may be formed as a multilayer line at at least one portion. For example, the connection lines CL including an nth connection line CLn and an (n+1)th connection line CLn+1 may be formed as multilayer lines including a main line ML1 located in the same layer as bottom metal layers BML, a first sub-line SLI1 located in the same layer gate electrodes GE, and a second sub-line SLI2 located in the same layer as source and drain electrodes SE and DE. Accordingly, a delay of a power voltage (e.g., a first power voltage VDD and/or a second power voltage VSS) or a signal (e.g., scan signals), which is supplied to the multilayer lines, can be prevented or reduced, and the pixels PXL can be stably driven.

The circuit layer PCL may further include/define first contact holes CH1, second contact holes CH2, and third contact holes CH3, which are formed between the circuit layer PCL and the display layer DPL.

Each first contact hole CH1 may allow the electrical connection of each pixel circuit PXC, and a light-emitting unit EMU corresponding thereto, to each other. For example, a first contact hole CH1 corresponding to each first sub-pixel SPX1 may be formed between the first pixel circuit PXC1 and a first alignment electrode ALE1 of a first light-emitting unit EMU1, and may allow the first pixel circuit PXC1 and the first light-emitting unit EMU1 to be electrically connected to each other. A first contact hole CH1 corresponding to each second sub-pixel SPX2 may be formed between the second pixel circuit PXC2 and a first alignment electrode ALE1 of a second light-emitting unit EMU2, to thereby electrically connect the second pixel circuit PXC2 and the second light-emitting unit EMU2 to each other. A first contact hole CH1 corresponding to each third sub-pixel SPX3 may be formed between the third pixel circuit PXC3 and a first alignment electrode ALE1 of a third light-emitting unit EMU3 to thereby electrically connect the third pixel circuit PXC3 and the third light-emitting unit EMU3.

The second contact holes CH2 may electrically connect the second power line PL2 and second alignment electrodes ALE2 of light-emitting units EMU. For example, the second contact holes CH2 may be formed between second horizontal power lines HPL2 repeatedly located for every two or more horizontal lines and second alignment electrodes ALE2 of light-emitting units EMU located at the periphery of the second horizontal power lines HPL2 (e.g., overlapping with the second horizontal power lines HPL2). Accordingly, in a manufacturing process of pixels PXL (e.g., an alignment process of light-emitting elements LD), a second alignment signal may be supplied to the second alignment electrodes ALE2 through the second power line PL2.

The third contact holes CH3 may electrically connect/allow the electrical connection of the first power line PL1 and floating patterns (e.g. floating patterns FPT shown in FIG. 9) of the display layer DPL to each other. For example, the third contact holes CH3 may be formed between first horizontal power lines HPL1 repeatedly located for every two or more horizontal lines and floating patterns FPT overlapping with the first horizontal power lines HPL1. In one or more embodiments, the floating patterns FPT may be integrally formed respectively with first alignment electrodes ALE1 and third alignment electrodes ALE3 in a pixel process (e.g., a process for forming pixels PXL on the base layer BSL). Therefore, the floating patterns FPT along with the first alignment electrodes ALE1 and the third alignment electrodes ALE3 constitute a first alignment line. Accordingly, in an alignment process of the light-emitting elements LD, a first alignment signal may be supplied to the first alignment line through the first power line PL1. After the alignment process of the light-emitting elements LD is completed, the first alignment line is cut off at the periphery of the third contact holes CH3, so that the floating patterns FPT are separated from the first alignment electrodes ALE1. Accordingly, the sub-pixels SPX can be individually driven. In some embodiments, the floating patterns FPT may be separated from the third alignment electrodes ALE3.

Each of the first contact holes CH1, the second contact holes CH2, and the third contact holes CH3 may be configured as a single contact hole (or contact part) or a via hole, which is formed at a corresponding position, or may include two or more contact holes and/or two or more via holes, which are densely formed at a corresponding position, and may connect the same components to each other.

Each pixel circuit PXC may include a first transistor M1, a second transistor M2, a third transistor M3, and a capacitor Cst, which are located in each circuit area SPXA. For example, the first pixel circuit PXC1 may include a first transistor M1, a second transistor M2, a third transistor M3, and a capacitor Cst, which are located at a first circuit area SPXA1 of a corresponding pixel area PXA. The second pixel circuit PXC2 may include a first transistor M1, a second transistor M2, a third transistor M3, and a capacitor Cst, which are located at a second circuit area SPXA2 of a corresponding pixel area PXA. The third pixel circuit PXC3 may include a first transistor M1, a second transistor M2, a third transistor M3, and a capacitor Cst, which are located at a third circuit area SPXA3 of a corresponding pixel area PXA.

Each first transistor M1 may include a first semiconductor pattern SCP1, a first gate electrode GE1, a first source electrode SE1, and a first drain electrode DE1. In one or more embodiments, each first transistor M1 may further include a bottom metal layer BML.

The bottom metal layer BML may overlap with the first semiconductor pattern SCP1, the first gate electrode GE1, and the first source electrode SE1. In one or more embodiments, the bottom metal layer BML may be electrically connected to the first source electrode SE1 through at least one contact hole CH.

The first semiconductor pattern SCP1 may overlap with the first gate electrode GE1 and the bottom metal layer BML, and may be connected to the first source electrode SE1 and the first drain electrode DE1. For example, respective end portions of the first semiconductor pattern SCP1 may be electrically connected to the first source electrode SE1 and the first drain electrode DE1 through contact holes CH, respectively.

The first gate electrode GE1 may be connected to a lower electrode LE of the capacitor Cst and to a second source electrode SE2. For example, the first gate electrode GE may be integrally formed with the lower electrode LE of the capacitor Cst, and may be electrically connected to the second source electrode SE2 through at least one contact hole CH.

The first source electrode SE1 may be connected to an upper electrode UE of the capacitor Cst and to a third source electrode SE3. For example, the first source electrode SE1 may be integrally formed with the upper electrode UE of the capacitor Cst and the third source electrode SE3. The first source electrode SE1 may be connected to a light-emitting unit EMU of a corresponding sub-pixel SPX. For example, the first source electrode SE1 may be electrically connected to a first alignment electrode ALE1 and/or to a first contact electrode CNE1, and may be formed in the light-emitting unit EMU of the corresponding sub-pixel SPX. In one or more embodiments, the first source electrode SE1 of the first pixel circuit PXC1, the upper electrode UE of the capacitor Cst, and the third source electrode SE3 may be electrically connected to the first alignment electrode ALE1 of the first light-emitting unit EMU1 through the first contact hole CH1 formed between the first pixel circuit PXC1 and the first light-emitting unit EMU1, and may be electrically connected to a first contact electrode CNE1 of the first light-emitting unit EMU1.

The first drain electrode DE1 may be connected to the first power line PL1. For example, the first drain electrode DE1 may be electrically connected to a first vertical power line VPL1 through at least one contact hole CH.

Each transistor M2 may include a second semiconductor pattern SCP2, a second gate electrode GE2, the second source electrode SE2, and a second drain electrode DE2.

The second semiconductor pattern SCP2 may overlap with the second gate electrode GE2, and may be connected to the second source electrode SE2 and the second drain electrode DE2. For example, respective end portions of the second semiconductor pattern SCP2 may be electrically connected to the second source electrode SE2 and the second drain electrode DE2 through contact holes CH, respectively.

The second gate electrode GE2 may be connected to a scan line SL. For example, the second gate electrode GE2 may be electrically connected to a scan line SL (e.g., an nth scan line SLn) of a corresponding horizontal line through at least one contact hole CH.

The second source electrode SE2 may be connected to the lower electrode LE of the capacitor Cst and the first gate electrode GE1. For example, the second source electrode SE2 may be electrically connected to the lower electrode LE of the capacitor Cst and the first gate electrode GE1 through at least one contact hole CH.

The second drain electrode DE2 may be connected to a sub-data line of a corresponding sub-pixel SPX. For example, a second drain electrode DE2 of the first pixel circuit PXC1 may be electrically connected to a first sub-data line D1 through at least one contact hole CH. A second drain electrode DE2 of the second pixel circuit PXC2 may be electrically connected to a second sub-data line D2 through at least one contact hole CH. A second drain electrode DE2 of the third pixel circuit PXC3 may be electrically connected to a third sub-data line D3 through at least one contact hole CH.

Each third transistor M3 may include a third semiconductor pattern SCP3, a third gate electrode GE3, the third source electrode SE3, and a third drain electrode DE3.

The third semiconductor pattern SCP3 may overlap with the third gate electrode GE3, and may be connected to the third source electrode SE3 and the third drain electrode DE3. For example, respective end portions of the third semiconductor pattern SCP3 may be electrically connected to the third source electrode SE3 and the third drain electrode DE3 through contact holes CH.

The third gate electrode GE3 may be connected to each scan line SL, or may be connected to a separate control line SSL separated from the scan line SL. In one or more embodiments, the third gate electrode GE3 may be integrally formed with the second gate electrode GE2, and may be electrically connected to each scan line SL through at least one contact hole CH.

The third source electrode SE3 may be connected to the upper electrode UE of the capacitor Cst and the first source electrode SE1. For example, the third source electrode SE3 may be integrally formed with the upper electrode UE of the capacitor Cst and the first source electrode SE1.

The third drain electrode DE3 may be connected to a sensing line SENL. For example, the third drain electrode DE3 may be electrically connected to the corresponding sensing line SENL through at least one contact hole CH.

The capacitor Cst may include the lower electrode LE and the upper electrode UE.

The lower electrode LE of the capacitor Cst may be connected to the first gate electrode GE1 and the second source electrode SE2. For example, the lower electrode LE of the capacitor Cst may be integrally formed with the first gate electrode GE1, and may be electrically connected to the second source electrode SE2 through at least one contact hole CH.

The upper electrode UE of the capacitor Cst may be connected to the first source electrode SE1 and the third source electrode SE3. For example, the upper electrode UE of the capacitor Cst may be integrally formed with the first source electrode SE1 and the third source electrode SE3.

In one or more embodiments, the bottom metal layers BML and at least some lines (or portions of the lines) extending in the second direction DR2, which are provided in the display area DA, may be located in the same layer of the circuit layer PCL (e.g., the first conductive layer inside the circuit layer PCL). The semiconductor patterns SCP provided in the display area DA may be located in the same layer of the circuit layer PCL (e.g., the semiconductor layer inside the circuit layer PCL). The gate electrodes GE, the lower electrodes LE of the capacitors Cst, and/or at least one sub-line (e.g., the first sub-lines SLI1 of the connection lines CL), which are provided in the display area DA, may be located in the same layer of the circuit layer PCL (e.g., the second conductive layer (e.g., a gate layer) inside the circuit layer PCL). The source electrodes SE, the drain electrodes DE, the upper electrodes UE of the capacitors Cst, at least some lines extending in the first direction DR1, and/or at least one sub-line (e.g., the second sub-lines SLI2 of the connection lines CL), which are provided in the display area DA, may be located in the same layer of the circuit layer PCL (e.g., the third conductive layer (e.g., a source-drain layer) inside the circuit layer PCL).

In the one or more embodiments corresponding to FIGS. 6 to 8, the circuit elements and the lines of the circuit layer PCL are efficiently located, so that the area occupied by each pixel circuit PXC can be reduced or minimized. Accordingly, the above-described embodiments can be usefully applied to a high-resolution display device DD in which the area of a pixel area PXA is narrow, and the like.

In addition, in the second direction DR2, lines extending in the first direction DR1 may be located at respective sides of light-emitting units EMU of sub-pixels SPX to be immediately adjacent to the light-emitting units EMU. For example, in the second direction DR2, the nth scan line SLn and the first horizontal power line HPL1 may be located at respective sides of light-emitting units EMU provided in the first pixel PXL1 to be immediately adjacent to the light-emitting units EMU of the first pixel PXL1. Similarly, the (n+1)th scan line SLn+1 and the second horizontal power line HPL2 may be located at respective sides of light-emitting units EMU provided in the second pixel PXL2 to be immediately adjacent to the light-emitting units EMU of the second pixel PXL2. Accordingly, in the display layer DPL formed on the circuit layer PCL, the height of a bank (e.g., a first bank BNK1 shown in FIG. 9) can be increased or maximized.

Thus, the capacity of emission areas EA can be increased, and overflow of a light-emitting element ink including light-emitting elements LD over the non-emission area NEA adjacent to both ends of the emission areas EA (e.g., the non-emission area NEA that is adjacent to the emission areas EA in the second direction DR2, and that has end portions of first alignment electrodes ALE1, which are located therein) in a process of supplying the light-emitting elements LD to the emission areas EA, can be prevented or reduced. Accordingly, a first alignment line can be stably separated into first alignment electrodes ALE1 (and/or third alignment electrodes ALE3) in a subsequent process. In accordance with the above-described embodiments, a short-circuit defect occurring in the display area DA (e.g., a short-circuit defect that may occur because first alignment electrodes ALE1 are not stably separated) can be prevented and reduced.

FIG. 9 is a plan view illustrating a display layer DPL of the display area DA in accordance with one or more embodiments of the present disclosure. For example, FIG. 9 illustrates one or more embodiments of a structure of the display layer DPL, based on an area in which light-emitting units EMU of the first pixel PXL1 and the second pixel PXL2, which are shown in FIG. 6, and in which a bank pattern BNP and a first bank BNK1 at the periphery thereof, are located. In FIG. 9, some lines located in the circuit layer PCL (e.g., an nth scan line SLn, an (n+1)th scan line SLn+1, a first horizontal power line HPL1, and a second horizontal power line HPL2, which are located inside and/or the periphery of the first pixel PXL1 and the second pixel PXL2) are indicated by a dotted line such that positions of the light-emitting units EMU in accordance with the above embodiments can be more clearly represented.

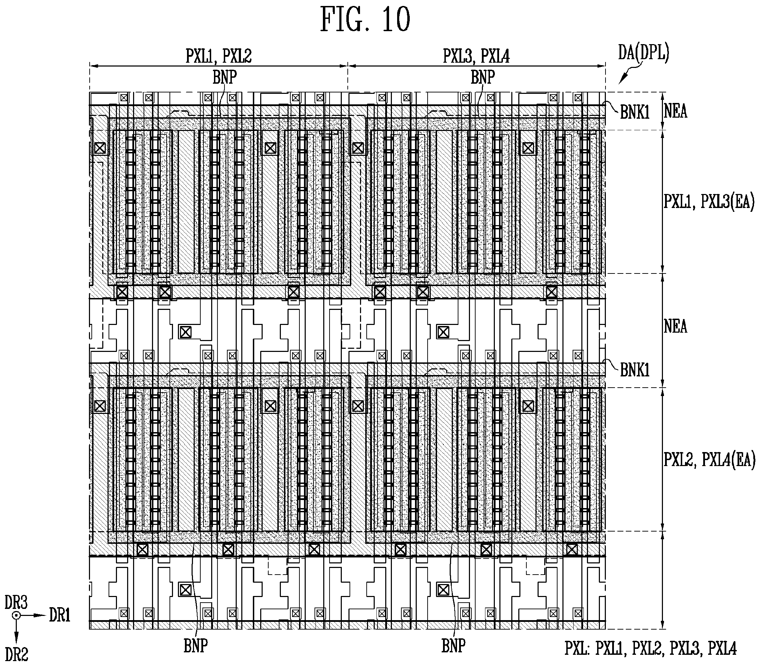

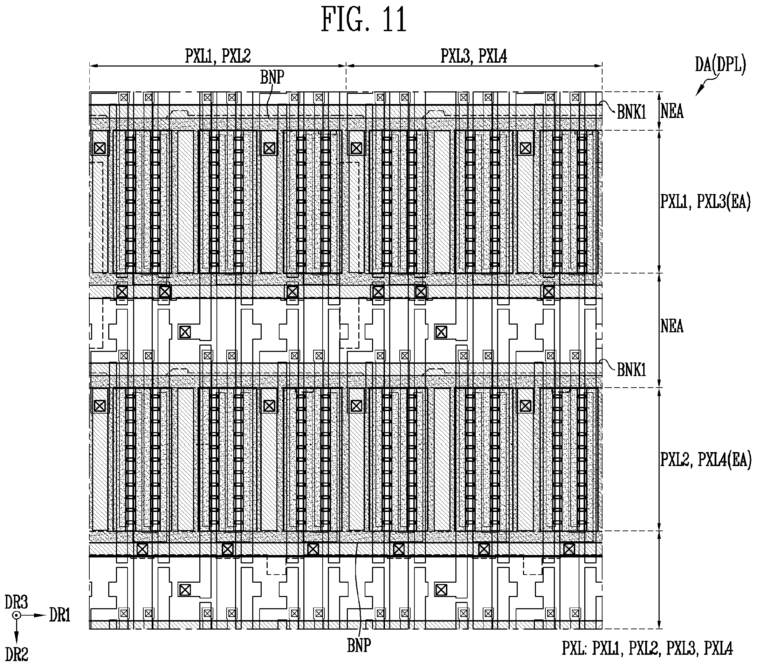

FIGS. 10 and 11 are plan views illustrating display layers DPL of the display area DA in accordance with embodiments of the present disclosure. For example, FIGS. 10 and 11 illustrate different embodiments in relation to bank patterns BNP, based on an area in which four pixels PXL (e.g., a first pixel PXL1, a second pixel PXL2, a third pixel PXL3, and a fourth pixel PXL4) adjacent to each other in the first direction DR1 and the second direction DR2 are located.

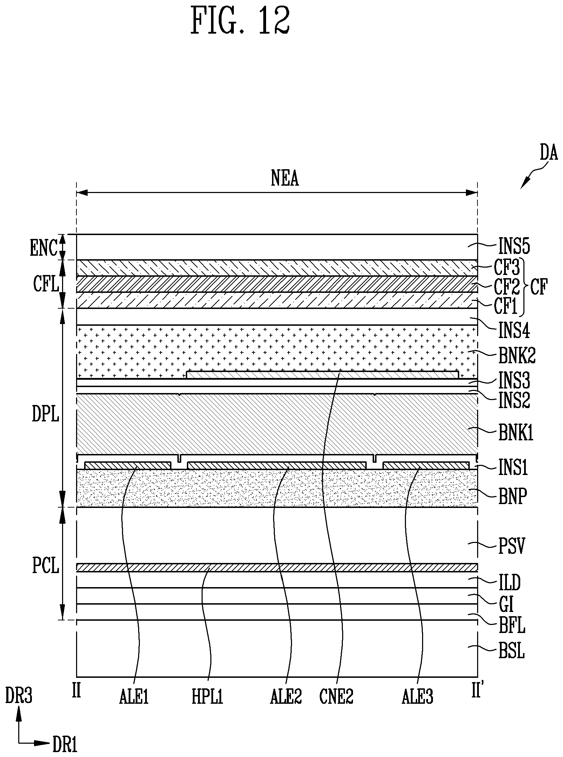

FIG. 12 is a sectional view illustrating a display area DA in accordance with one or more embodiments of the present disclosure. For example, FIG. 12 schematically illustrates a section of the display area DA, which corresponds to the line II-II' shown in FIG. 9.

First, referring to FIGS. 3 to 9, sub-pixels SPX of each pixel PXL may include emission areas EA arranged in the first direction DR1, and light-emitting units EMU provided in the emission areas EA.

In one or more embodiments, the light-emitting unit EMU (or the emission areas EA corresponding to the light-emitting units EMU) may be located between a first line and a second line, each of which extending in the first direction DR1 and being spaced apart from each other in the second direction DR2. The first line and the second line may be immediately adjacent to the light-emitting units EMU in the second direction DR2.

For example, first, second, and third light-emitting units EMU1, EMU2, and EMU3 of the first pixel PXL1 (or first, second, and third emission areas EA1, EA2, and EA3 corresponding to the first, second, and third light-emitting units EMU1, EMU2, and EMU3 of the first pixel PXL1) may be located between an nth scan line SLn for supplying a scan signal to the first pixel PXL1 and a first horizontal power line HPL1, and may be arranged along the first direction DR1 between the nth scan line SLn and the first horizontal power line HPL1. First, second, and third light-emitting units EMU1, EMU2, and EMU3 of the second pixel PXL2 (or first, second, and third emission areas EA1, EA2, and EA3 corresponding to the first, second, and third light-emitting units EMU1, EMU2, and EMU3 of the second pixel PXL2) may be located between an (n+1)th scan line SLn+1 for supplying a scan signal to the second pixel PXL2 and a second horizontal power line HPL2, and may be arranged along the first direction DR1 between the (n+1)th scan line SLn+1 and the second horizontal power line HPL2.

Each light-emitting unit EMU may include at least one pair of alignment electrodes ALE, at least one light-emitting element LD, and at least one pair of contact electrodes CNE. For example, each light-emitting unit EMU may include a first alignment electrode ALE1, a second alignment electrode ALE2, a third alignment electrode ALE3, first light-emitting elements LD1, second light-emitting elements LD2, a first contact electrode CNE1, a second contact electrode CNE2, and a third contact electrode CNE3, which are located in each emission area EA.

In each emission area EA, the first alignment electrode ALE1, the second alignment electrode ALE2, and the third alignment electrode ALE3 may be spaced apart from each other along the first direction DR1, and each may extend in the second direction DR2. The first light-emitting elements LD1 may be located between the first alignment electrode ALE1 and the second alignment electrode ALE2, and the second light-emitting elements LD2 may be located between the second alignment electrode ALE2 and the third alignment electrode ALE3. That light-emitting elements LD are located between alignment electrodes ALE may mean that, when viewed on a plane, at least a portion of each of the light-emitting elements LD is located in an area between the alignment electrodes ALE and/or at the periphery thereof. The light-emitting elements LD may or may not overlap with alignment electrodes ALE located at the periphery thereof.

In one or more embodiments, light-emitting elements LD may be prepared in a form in which the light-emitting elements LD are dispersed in a solution to be supplied to each emission area EA through an inkjet printing process, or the like. For example, a light-emitting element ink including light-emitting elements LD may be supplied to each emission area EA defined by a first bank BNK1. When alignment signals are respectively applied to alignment electrodes ALE (or alignment lines) of sub-pixels SPX in a state in which light-emitting elements LD are supplied to each emission area EA, the light-emitting elements LD may be aligned between the alignment electrodes ALE. For example, the first light-emitting elements LD1 may be aligned in a first light-emitting element arrangement area AR1 such that first end portions EP1 of the first light-emitting elements LD1 are adjacent to the first alignment electrode ALE1, and such that second end portions EP2 of the first light-emitting elements LD1 are adjacent to the second alignment electrode ALE2. The second light-emitting elements LD2 may be aligned in a second light-emitting element arrangement area AR2 such that first end portions EP1 of the second light-emitting elements LD2 are adjacent to the third alignment electrode ALE3, and such that second end portions EP2 of the second light-emitting elements LD2 are adjacent to the second alignment electrode ALE2. After the light-emitting elements LD are aligned, a solvent of the light-emitting element ink may be removed through a drying process or the like.

In one or more embodiments, first alignment electrodes ALE1, third alignment electrodes ALE3, and floating patterns FPT, which are provided in the display area DA, may be formed to be firstly connected to each other in a pixel process, thereby constituting a first alignment line. Accordingly, in an alignment process of the light-emitting elements LD, a first alignment signal may be supplied to the first alignment line through the first power line PL1. After the alignment process of the light-emitting elements LD is completed, the first alignment line may be cut off at the periphery of third contact holes CH3, so that the floating patterns FPT can be separated from the first alignment electrodes ALE1 (or the first alignment electrodes ALE1 and the third alignment electrodes ALE3).

In one or more embodiments, some alignment electrodes ALE of light-emitting units EMU adjacent to each other in the first direction DR1 may be formed to be first connected to each other, thereby constituting one alignment line, and may be separated from each other as individual alignment electrodes ALE after the light-emitting element LD are completely aligned. For example, first alignment electrodes ALE1 provided in a first light-emitting unit EMU1 of each pixel PXL may be formed to be connected to third alignment electrodes ALE3 provided in a third light-emitting unit EMU3 of another pixel PXL adjacent to the pixel PXL in the first direction DR1, thereby constituting one first alignment line, and then may be separated from each other in a subsequent process. A first alignment electrode ALE1 provided in a second light-emitting unit EMU2 of each pixel PXL may be formed to be connected to a third alignment electrode ALE3 provided in a first light-emitting unit EMU1 of the corresponding pixel PXL, thereby constituting one first alignment line, and then may be separated from each other in a subsequent process. A first alignment electrode ALE1 provided in a third light-emitting unit EMU3 of each pixel PXL may be formed to be connected to a third alignment electrode ALE3 provided in a second light-emitting unit EMU2 of the corresponding pixel PXL, thereby constituting one first alignment line, and then may be separated from each other in a subsequent process.

In one or more embodiments, at least some of the alignment electrodes ALE adjacent to each other in the second direction DR2 may be formed to be first connected to each other, thereby constituting one alignment line, and may be separated from each other as individual alignment electrodes ALE after the light-emitting element LD are completely aligned. For example, first alignment electrodes ALE1 may be continuously formed along the second direction DR2 in the display area DA, thereby constituting a first alignment line, and then may be separated from each other as individual first alignment electrodes ALE1 by being cut off between emission areas EA adjacent to each other in the second direction DR2 after the light-emitting element LD are completely aligned. In one or more embodiments, after the light-emitting elements LD are completely aligned, a first alignment line may be etched in a non-emission area NEA adjacent to each emission area EA in the second direction DR2. Therefore, the first alignment line may be separated into first alignment electrodes ALE1 of sub-pixels SPX. Each first alignment electrode ALE may include an end portion located at a portion of a non-emission area NEA adjacent to an emission area EA of a corresponding sub-pixel SPX in the second direction DR2.

In one or more embodiments, third alignment electrodes ALE3 may be continuously formed along the second direction DR2 in the display area DA, and then may be separated from each other as individual third alignment electrodes ALE3 by being cut off between emission areas EA adjacent to each other in the second direction DR2 after the light-emitting elements LD are completely aligned. Each third alignment electrode ALE3 may include an end portion located at a portion of a non-emission area NEA adjacent to an emission area EA of a corresponding sub-pixel SPX.

A first alignment electrode ALE1 of each sub-pixel SPX may be electrically connected to a pixel circuit PXC of the corresponding sub-pixel SPX through each first contact hole CH1, and may be electrically connected to a first contact electrode CNE1 of a corresponding light-emitting unit EMU through each fourth contact hole CH4. Also, the first alignment electrode ALE1 of each sub-pixel SPX may be electrically connected to light-emitting elements LD of the corresponding light-emitting unit EMU through the first contact electrode CNE1. For example, each first alignment electrode ALE1 may be electrically connected to first end portions EP1 of first light-emitting elements LD1 located in each emission area EA through each first contact electrode CNE1.

In one or more embodiments, second alignment electrodes ALE2 of at least two light-emitting units EMU adjacent to each other in the second direction DR2 may be connected to each other. For example, a second alignment electrode ALE2 provided in the first light-emitting unit EMU1 of the first pixel PXL1 and a second alignment electrode ALE2 provided in the first light-emitting unit EMU1 of the second pixel PXL2 may be integrally formed, and may constitute one integrated second alignment electrode ALE2. In some embodiments, second alignment electrodes ALE2 arranged in the second direction DR2 in the display area DA may be integrally formed, but embodiments are not limited thereto. In an alignment process of light-emitting elements LD, second alignment electrodes ALE2 may be connected to each other to constitute a second alignment line. After the light-emitting elements LD are completely aligned, second alignment electrodes ALE2 extending along the second direction DR2 in the display area DA may be separated from each other by being cut off in a unit of at least two pixel row, or may be integrally formed without being cut off.

The second alignment electrodes ALE2 may be electrically connected to a second power line PL2 (e.g., second horizontal power lines HPL2) through second contact holes CH2. The second alignment electrodes ALE2 may be supplied with a second alignment signal through the second power line PL2 in an alignment process of the light-emitting elements LD. The first alignment signal and the second alignment signal may have different waveforms, different phases, and/or different phases. Accordingly, an electric field is formed between the first alignment line and the second alignment electrodes ALE (or the second alignment line formed by the second alignment electrodes ALE2), so that the light-emitting elements LD can be aligned between the first alignment line and the second alignment electrodes ALE2. For example, first light-emitting elements LD1 may be aligned in a first light-emitting element arrangement area AR1 between a first alignment ALE1 and a second alignment electrode ALE2 of light-emitting unit EMU, and second light-emitting elements LD2 may be aligned in a second light-emitting element arrangement area AR2 between the second alignment electrode ALE2 and a third alignment electrode ALE3 of the light-emitting unit EMU. Each light-emitting element arrangement area AR may be surrounded by a bank pattern BNP.

When the display device DD is driven, the first power voltage VDD may be applied to the first alignment electrodes ALE1 through the first power line PL1 and the pixel circuit PXC, and the second power voltage VSS may be applied to the second alignment electrodes ALE2 through the second power line PL2.

The first contact electrode CNE1 may be located on the first end portions EP1 of the first light-emitting elements LD1 and the first alignment electrode ALE1. In one or more embodiments, the first contact electrode CNE1 may be in contact with and/or electrically connected to the first end portions EP1 of the first light-emitting elements LD1, and may be electrically connected to the first alignment electrode ALE1 through a fourth contact hole CH4. In one or more embodiments, the fourth contact hole CH4 may be formed in the first insulating layer INS1 shown in FIG. 7, and may be formed in a non-emission area NEA at the outside of an emission area EA. In one or more embodiments, fourth contact holes CH4 of sub-pixels SPX may be located at the outside of the emission area EA, and may be formed in an area not overlapping with the first bank BNK1. The fourth contact holes CH4 can be suitably formed on a relatively flat area while avoiding an area in which a step difference caused by the first bank BNK1 occurs. The position of the fourth contact hole CH4 may be changed in some embodiments.

The second contact electrode CNE2 may be located on the second end portions EP2 of the first light-emitting elements LD1, on a portion of the second alignment electrode ALE2, on the first end portions EP1 of the second light-emitting elements LD2, and on the third alignment electrode ALE3. In one or more embodiments, the second contact electrode CNE2 may be an electrode having left/right pattern parts such as a "U" shape. The left pattern part of the second contact electrode CNE2 may be located on the second end portions EP2 of the first light-emitting elements LD1 and on the portion of the second alignment electrode ALE2, and the right pattern part of the second contact electrode CNE2 may be located on the first end portions EP1 of the second light-emitting elements LD2 and on the third alignment electrode ALE3. In one or more embodiments, the second contact electrode CNE2 may be in contact with and/or electrically connected to the second end portions EP2 of the first light-emitting elements LD1 and to the first end portions EP1 of the second light-emitting elements LD2. The first light-emitting elements LD1 and the second light-emitting elements LD2 may be connected in series to each other by the second contact electrode CNE2.

The third contact electrode CNE3 may be located on the second end portions EP2 of the second light-emitting elements LD2 and another portion of the second alignment electrode ALE2. In one or more embodiments, the third contact electrode CNE3 may be in contact with and/or electrically connected to the second end portions EP2 of the second light-emitting elements LD2, and may be electrically connected to the second alignment electrode ALE2 through a fifth contact hole CH5. In one or more embodiments, the fifth contact hole CH5 may be formed in the first insulating layer INS1 shown in FIG. 7, and may be formed in the non-emission area NEA at the outside of the emission area EA. In one or more embodiments, fifth contact holes CH5 of sub-pixels SPX may be located at the outside of the emission area EA, and may be formed in an area not overlapping with the first bank BNK1. The fifth contact holes CH5 can be suitably formed on a relatively flat area while avoiding an area in which a step different caused by the first bank BNK1 occurs. The positions of the fifth contact holes CH5 may be changed in some embodiments.

The shapes, sizes, numbers, positions, and/or mutual arrangement structure of alignment electrodes ALE and contact electrodes CNE may be changed in some embodiments.

Bank patterns BNP may be located on the bottom of the alignment electrodes ALE. In one or more embodiments, the bank patterns BNP may be formed as individual patterns formed to be separated from each other, corresponding to each pixel PXL as shown in FIG. 10. For example, pixels PXL (e.g., a first pixel PXL1 and a third pixel PXL3, or a second pixel PXL2 and a fourth pixel PXL4) that each include sub-pixels SPX, and that are arranged in the first direction DR1, may include bank patterns BNP separated from each other. In one or more other embodiments, as shown in FIG. 11, bank patterns BNP corresponding to at least two pixels PXL adjacent to each other in the first direction DR1 (e.g., provided to the at least two pixels PXL) may be integrally formed to substantially form one bank pattern BNP. In one or more embodiments, one integrated bank pattern BNP may be located for every horizontal line of the display area DA.

Each bank pattern BNP may include/define openings OPN respectively corresponding to light-emitting element arrangement areas AR provided in emission areas EA of a corresponding pixel PXL. For example, each bank pattern BNP may include first openings OPN1 corresponding to first light-emitting element arrangement areas AR1 provided in the first, second, and third light-emitting units EMU1, EMU2, and EMU3 of a corresponding pixel PXL, and second openings OPN2 corresponding to second light-emitting element arrangement areas AR2 provided in the first, second, and third light-emitting units EMU1, EMU2, and EMU3 of the corresponding pixel PXL. In one or more embodiments, the bank patterns BNP may further include third openings OPN3 formed between emission areas EA of the corresponding pixel PXL.

In one or more embodiments, emission areas EA of each pixel PXL (e.g., a first emission area EA1 of a first light-emitting unit EMU1, a second emission area EA2 of a second light-emitting unit EMU2, and a third emission area EA3 of a third light-emitting unit EMU3) may be located in an area between two lines (hereinafter, referred to as a "first line" and a "second line") that each extend in the first direction, and that are spaced apart from each other in the second direction DR2. In one or more embodiments, the first, second, and third emission areas EA1, EA2, and EA3 of each pixel PXL may be arranged in the first direction DR1 in the area between the first line and the second line.

For example, first, second, and third emission areas EA1, EA2, and EA3 of the first pixel PXL1 may be located between an nth scan line SLn and a first horizontal power line HPL1 in the second direction DR2, and may be arranged in the first direction DR1 between the nth scan line SLn and the first horizontal power line HPL1. First, second, and third emission areas EA1, EA2, and EA3 of the second pixel PXL2 may be located between an (n+1)th scan line SLn+1 and a second horizontal power line HPL2 in the second direction DR2, and may be arranged in the first direction DR1 therebetween.

A bank pattern BNP of each pixel PXL may overlap with the first line and the second line. For example, a bank pattern BNP corresponding to the first pixel PXL1 (e.g., a bank pattern BNP formed in the first pixel PXL1) may overlap with the nth scan line SLn and the first horizontal power line HPL1, and a bank pattern BNP corresponding to the second pixel PXL2 (e.g., a bank pattern BNP formed in the second pixel PXL2) may overlap with the (n+1)th scan line SLn+1 and the second horizontal power line HPL2.

In one or more embodiments, bank patterns BNP of sub-pixels SPX provided in each pixel PXL may be connected to each other in the first direction DR1. Therefore, the bank patterns BNP may be substantially formed as one bank pattern BNP. Each bank pattern BNP may include a first pattern part BNP_1 and a second pattern part BNP_2 respectively adjacent to first edge areas and second edge areas of emission areas EA provided in a corresponding pixel PXL. The first edge areas and the second edge areas of the emission areas EA may be located at both ends of the emission areas EA in the second direction DR2. The first pattern part BNP_1 and the second pattern part BNP_2 of the bank pattern BNP may overlap with a first line and a second line of a corresponding pixel PXL and/or a corresponding horizontal line. For example, the first pattern part BNP_1 of the bank pattern BNP may overlap with a first line (e.g., a scan line SLn electrically connected to the corresponding pixel PXL) adjacent to the first edge areas of the emission areas EA provided in the corresponding pixel PXL, and the second pattern part BNP_2 of the bank pattern BNP may overlap with a second line (e.g., a first horizontal power line HPL1 or a second horizontal power line HPL2, which is located between second and third pixel circuits PXC2 and PXC3 of the corresponding horizontal line) adjacent to the second edge areas of the emission areas EA provided in the corresponding pixel PXL. In addition, each bank pattern BNP may further include a third pattern part BNP_3 that extends in a direction that is different from a direction in which the first pattern part BNP_1 and the second pattern part BNP_2 extend, and that connects the first pattern part BNP_1 and the second pattern part BNP_2 to each other.

For example, the bank pattern BNP of the first pixel PXL1 may include a first pattern part BNP_1 that overlaps with an nth scan line SLn, and that is continuously formed along the first direction DR1 at the periphery of the emission areas EA of the first pixel PXL1 (e.g., a portion immediately adjacent to the first edge areas of the first, second, and third emission areas EA1, EA2, and EA3 of the first pixel PXL1), and a second pattern part BNP_2 that overlaps with a first horizontal power line HPL1 (e.g., a first horizontal power line HPL1 located between second and third pixel circuits PXC2 and PXC3 of the first pixel PXL1), and that is continuously formed along the first direction DR1 at the periphery of the emission areas EA of the first pixel PXL1 (e.g., a portion immediately adjacent to the second edge areas of the first, second, and third emission areas EA1, EA2, and EA3 of the first pixel PXL1). In addition, the bank pattern BNP of the first pixel PXL1 may include third pattern parts BNP_3 located at both sides of each light-emitting element arrangement area AR of the first pixel PXL1 in the first direction DR1. The third pattern parts BNP_3 may extend in the second direction DR2.

Similarly, the bank pattern BNP of the second pixel PXL2 may include a first pattern part BNP_1 that overlaps with an (n+1)th scan line SLn, and that is continuously formed along the second direction DR1 at the periphery of the emission areas EA of the first pixel PXL2 (e.g., a portion immediately adjacent to the first edge areas of the first, second, and third emission areas EA1, EA2, and EA3 of the second pixel PXL2), and a second pattern part BNP_2 that overlaps with a second horizontal power line HPL2 (e.g., a second horizontal power line HPL2 located between second and third pixel circuits PXC2 and PXC3 of the second pixel PXL2), and that is continuously formed along the first direction DR1 at the periphery of the emission areas EA of the second pixel PXL2 (e.g., a portion immediately adjacent to the second edge areas of the first, second, and third emission areas EA1, EA2, and EA3 of the second pixel PXL2). In addition, the bank pattern BNP of the second pixel PXL2 may include third pattern parts BNP_3 located at both sides of each light-emitting element arrangement area AR of the second pixel PXL2 in the first direction DR1. The third pattern parts BNP_3 may extend in the second direction DR2.

A first bank BNK1 may be located in the display area DA in which bank patterns BNP, alignment electrodes ALE, and the like are located. The first bank BNK1 may include openings OPN corresponding emission areas EA of sub-pixels SPX, and surround the emission areas EA.

The first bank BNK1 may be located in a portion of the non-emission area NEA. For example, the first bank BNK1 may be opened between two adjacent pixel rows. In one or more embodiments, the first bank BNK1 may be opened at least a portion of areas in which a first alignment line is cut off to separate the first alignment line into individual first alignment electrodes ALE1 (e.g., a peripheral area of floating patterns FPT and an area between adjacent pixel rows).

The first bank BNK1 may overlap with a first line, a second line, and a bank pattern BNP in an area in which the first line and the second line, which are adjacent to emission areas EA of a corresponding horizontal line (e.g., each pixel row) in the second direction DR2. In one or more embodiments, the first bank BNK1 may be continuously formed along the first direction DR1 at a portion at which the first bank BNK1 overlaps with the first line, the second line, and the bank pattern BNP. For example, the first line (e.g., a scan line SL of a corresponding horizontal line), the bank pattern BNP (e.g., the first pattern part BNP_1 of the bank pattern BNP), and the first bank BNK1 may completely overlap with each other in a non-emission area NEA immediately adjacent to first edge areas of first, second, and third emission areas EA1, EA2, and EA3 of each pixel PXL. Similarly, the second line (e.g., a first horizontal power line HPL1 or a second horizontal power line HPL2, which is located on the corresponding horizontal line), the bank pattern BNK (e.g., the second pattern part BNP_2 of the bank pattern BNP), and the first bank BNK1 may completely overlap with each other in a non-emission area NEA immediately adjacent to second edge areas of first, second, and third emission areas EA1, EA2, and EA3 of each pixel PXL. In one or more embodiments, the first line and the second line may be provided in a conductive layer (e.g., a third conductive layer) located relatively close the display layer DPL (e.g., closest to the display layer DPL) among conductive layers provided in the circuit layer PCL.

As described above, in a non-emission area NEA adjacent to both ends of emission areas EA in at least the second direction DR2, the first or second line, the bank pattern BNP, and the first bank BNK1 overlap with each other, so that the height of the first bank BNK1 can be increased or maximized. For example, in a non-emission area NEA immediately adjacent to second edge areas (bottom edge areas) of emission areas EA, the first horizontal power line HPL1, the bank pattern BNP, and the first bank BNK1 may continuously overlap with each other along the first direction DR1 as shown in FIG. 12.

At the portion at which the first bank BNK1 overlaps with the first horizontal power line HPL1 and the bank pattern BNP, the first bank BNK1 may be formed relatively high, as compared with a portion at which the first bank BNK1 does not overlap with the first horizontal power line HPL1 and/or the bank pattern BNP. Accordingly, in a process of supplying a light-emitting element ink including light-emitting elements LD in each emission area EA defined by the first bank BNK1, the capacity of the light-emitting element ink that can be accommodated in each emission area EA can be increased, and overflow of the light-emitting element ink over the non-emission area NEA can be prevented or reduced.

As described above, the display device DD in accordance with the embodiments of the present disclosure may include a first line (e.g., a scan line SL of each horizontal line) extending in the first direction DR1, a second line (e.g., a first horizontal power line HPL1 or a second horizontal power line HPL2) spaced apart from the first line in the second direction DR2, emission areas EA (e.g., first, second, and third emission areas EA1, EA2, and EA3) located between the first line and the second line, sub-pixels SPX (e.g., first, second, and third sub-pixels SPX1, SPX2, and SPX3) including light-emitting elements LD located in the emission areas EA, a bank pattern BNP that overlaps with the first line and the second line and that includes openings respectively corresponding to light-emitting element arrangement areas AR in which the light-emitting elements LD are arranged, and a first bank BNK1 that surrounds the emission areas EA and overlaps with the first line, the second line, and the bank pattern BNP. In accordance with the embodiments of the present disclosure, in a non-emission area NEA immediately adjacent to both ends of emission areas EA of sub-pixels SPX in the second direction DR2, the height of the first bank BNK1 can be increased or maximized. Accordingly, the capacity amount of emission areas EA can be increased, and overflow of a light-emitting element ink over the non-emission area NEA at the periphery of the emission area EA (e.g., the non-emission area NEA adjacent to both ends of the emission areas EA in the second direction DR2) in a process of supplying the light-emitting elements LD to the emission areas EA can be prevented or reduced. Accordingly, a first alignment line can be stably separated into individual first alignment electrodes ALE1 in a subsequent process. In addition, the likelihood of a short-circuit defect that may occur because first alignment electrodes ALE1 are not separated can be prevented and reduced.

In the display device in accordance with the present disclosure, in a non-emission area adjacent to emission areas of sub-pixels, a first or second line, a bank pattern, and a first bank overlap with each other, so that the height of the first bank can be increased or maximized. Accordingly, the capacity amount of emission areas can be increased, and overflow of a light-emitting element ink including light-emitting elements over the non-emission area in a process of supplying the light-emitting elements to the emission areas can be prevented or reduced. Thus, a first alignment line can be stably separated into first alignment electrodes in a sub-sequent process, and the likelihood of a short-circuit defect can be prevented or reduced.

Embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with one or more embodiments may be used singly or in combination with features, characteristics, and/or elements described in connection with other embodiments, unless otherwise specifically indicated. Accordingly, it will be understood by those of skill in the art that various changes in form and details may be made without departing from the scope of the present disclosure as set forth in the following claims, with functional equivalents thereof to be included therein.

## Claims

1. A display device comprising:
a first line extending in a first direction;
a second line spaced apart from the first line in a second direction;
sub-pixels comprising emission areas between the first line and the second line;
light-emitting elements in light-emitting element arrangement areas in the emission areas;
a bank pattern overlapping with the first line and the second line, and defining openings corresponding to the light-emitting element arrangement areas; and
a bank surrounding the emission areas, and overlapping with the first line, the second line, and the bank pattern.

2. The display device of claim 1, wherein the second line extends in the first direction, and
wherein the bank pattern comprises:
a first pattern part overlapping the first line, and continuously formed along the first direction at a periphery of the emission areas;
a second pattern part overlapping the second line, and continuously formed along the first direction at the periphery of the emission areas; and
third pattern parts at respective sides of the light-emitting element arrangement areas in the first direction, and extending in the second direction.

3. The display device of claim 2, wherein the bank is continuously formed along the first direction at a portion overlapping with the first pattern part and the second pattern part.

4. The display device of any one of claims 1 to 3, wherein the first line is a scan line configured to transmit a scan signal, and
wherein the second line is a power line configured to transmit a first power voltage or a second power voltage.

5. The display device of any one of claims 1 to 4, wherein the sub-pixels comprise a first alignment electrode at a periphery of first end portions of the light-emitting elements, and extending in the second direction, and
wherein the first alignment electrode comprises an end portion at a portion of a non-emission area adjacent to an emission area of a corresponding sub-pixel in the second direction.

6. The display device of claim 5, wherein the first alignment electrode is electrically connected to the first end portions of the light-emitting elements, optionally wherein:
the sub-pixels further comprise a pixel circuit electrically connected to the first alignment electrode.

7. The display device of claim 5 or claim 6, wherein the sub-pixels further comprise a second alignment electrode at a periphery of second end portions of the light-emitting elements, and extending in the second direction, optionally wherein:
the display device further comprises a power line electrically connected to the second alignment electrode.

8. The display device of any one of claims 1 to 7, wherein the sub-pixels comprise a first sub-pixel, a second sub-pixel, and a third sub-pixel, which constitute one pixel, and respectively comprise a first emission area, a second emission area, and a third emission area, and that are arranged in the first direction between the first line and the second line, optionally wherein:
the first line, the bank pattern, and the bank completely overlap with each other in a non-emission area immediately adjacent to first edge areas of the first emission area, the second emission area, and the third emission area, and
wherein the second line, the bank pattern, and the bank completely overlap with each other in a non-emission area immediately adjacent to second edge areas of the first emission area, the second emission area, and the third emission area.

9. The display device of claim 8, wherein the first sub-pixel further comprises a first pixel circuit electrically connected to light-emitting elements in the first emission area among the light-emitting elements,
wherein the second sub-pixel further comprises a second pixel circuit electrically connected to light-emitting elements in the second emission area among the light-emitting elements, and
wherein the third sub-pixel further comprises a third pixel circuit electrically connected to light-emitting elements in the third emission area among the light-emitting elements.

10. The display device of claim 9, wherein the first pixel circuit, the second pixel circuit, and the third pixel circuit are arranged in the second direction.

11. The display device of claim 10, wherein:
(i) the second line is between the second pixel circuit and the third pixel circuit; and/or
(ii) the first pixel circuit and the third pixel circuit are between the first line and the second line.

12. The display device of claim 1, wherein the sub-pixels comprise:
a light-emitting unit comprising at least one light-emitting element in a corresponding emission area among the light-emitting elements, and electrodes electrically connected to the at least one light-emitting element; and
a pixel circuit comprising circuit elements electrically connected to the light-emitting unit.

13. The display device of claim 12, further comprising:
a circuit layer comprising pixel circuits of the sub-pixels, the first line, and the second line; and
a display layer overlapping with the circuit layer, and comprising light-emitting units of the sub-pixels, optionally wherein:
the circuit layer comprises conductive layers sequentially arranged along a third direction crossing the first direction and the second direction, and
wherein a conductive layer closest to the display layer among the conductive layers comprises the first line and the second line.

14. The display device of claim 1, further comprising at least two pixels each comprising sub-pixels among the sub-pixels, the at least two pixels being arranged in the first direction,
wherein the bank pattern comprises individual patterns formed by separating patterns corresponding to the at least two pixels from each other, or comprises an integrated pattern in which patterns corresponding to the at least two pixels are integrally formed.

15. A display device according to claim 1 wherein:
the second line extends in the first direction;
the sub-pixels comprise:
a first sub-pixel comprising first light-emitting elements in a first emission area between the first line and the second line;
a second sub-pixel comprising second light-emitting elements in a second emission area that is adjacent to the first emission area in the first direction, and that is between the first line and the second line; and
a third sub-pixel comprising third light-emitting elements in a third emission area that is adjacent to the second emission area in the first direction, and that is between the first line and the second line;
the openings in the bank pattern respectively correspond to light-emitting element arrangement areas in the first emission area, the second emission area, and the third emission area; and
the bank surrounds the first to third emission areas,
wherein, at a portion immediately adjacent to both ends of the first emission area, the second emission area, and the third emission area in the second direction, the bank pattern and the bank overlap with the first line and the second line and are continuously formed along the first direction.
